# FASCICULE DE BREVET EUROPEEN

(11) **EP 4 030 621 B1**
(45) Date de publication et mention de la délivrance du brevet: **02.08.2023**
(21) Numéro de dépôt: 21206893.6
(22) Date de dépôt: 08.11.2021
(51) Int. Cl.: H03K 5/13, H03K 5/24

(54) **COMPARATEUR DYNAMIQUE**
DYNAMISCHER KOMPARATOR
DYNAMIC COMPARATOR

(30) Priorité: 15.01.2021 FR 2100387
(43) Date de publication de la demande: 20.07.2022
(73) Titulaire: Commissariat à l'Énergie Atomique et aux Énergies Alternatives, 75015 Paris (FR)
(72) Inventeur: VERDANT, Arnaud, 38054 GRENOBLE CEDEX 9 (FR)
(74) Mandataire: Cabinet Beaumont

(56) Documents cités:
- WO-A1-2019/229678
- US-A1- 2015 028 930
- SHIM MINSEOB ET AL: "Edge-Pursuit Comparator: An Energy-Scalable Oscillator Collapse-Based Comparator With Application in a 74.1 dB SNDR and 20 kS/s 15 b SAR ADC", IEEE JOURNAL OF SOLID-STATE CIRCUITS, IEEE, USA, vol. 52, no. 4, 1 avril 2017 (2017-04-01), pages 1077-1090, XP011644063, ISSN: 0018-9200, DOI: 10.1109/JSSC.2016.2631299 [extrait le 2017-03-29]

## Description

### Domaine technique

La présente description concerne de façon générale les circuits électroniques, et plus particulièrement les comparateurs dynamiques qui peuvent être prévus dans de tels circuits électroniques.

### Technique antérieure

Les comparateurs dynamiques ont pour rôle d'effectuer la comparaison de deux signaux, de manière synchronisée avec un signal, typiquement un signal d'horloge, et de produire un signal binaire dont l'état binaire indique le résultat de cette comparaison. Le document WO 2019/229678 A1 décrit un exemple pour un comparateur dynamique d'une première tension (Vip) et d'une deuxième tension (Vin) avec deux branches qui sont rebouclées l'une sur l'autre de manière à former une structure en anneau.

Des comparateurs dynamiques sont par exemple utilisés dans des convertisseurs analogiques-numériques à approximations successives. Dans un tel convertisseur, le comparateur dynamique produit, de manière synchrone, un signal de sortie représentatif de la comparaison d'un signal analogique à une tension de seuil de quantification. Cela permet de quantifier le résidu du signal analogique qui est numérisé par le convertisseur, à chaque étape de la recherche par dichotomie du code numérique associé au signal analogique.

A titre d'exemple, un convertisseur analogique-numérique à approximations successives comprend un noeud de distribution de charges auquel sont connectées des premières électrodes d'une pluralité de capacités de valeurs croissantes. Le noeud est chargé avec le signal analogique à numériser alors qu'une tension basse donnée, typiquement une tension nulle, est appliquée sur les deuxièmes électrodes des capacités. Puis, une tension haute est appliquée sur la deuxième électrode de la capacité de plus forte valeur et la tension sur le noeud de distribution de charge est comparée, par un comparateur dynamique, avec une tension de quantification. Si la tension du noeud de distribution de charges est supérieure à la tension de quantification, la deuxième électrode qui était polarisée par la tension haute est repolarisée à la tension basse, sinon la tension haute est maintenue. Puis, ces opérations sont répétées de la capacité la plus forte à la capacité la plus faible, jusqu'à obtenir le code numérique associé au signal analogique à numériser, à partir des polarisations hautes ou basses appliquées sur chacune des deuxièmes électrodes des capacités.

Parmi les comparateurs dynamiques, les comparateurs dynamiques à verrouillage ("dynamic latched comparator" en anglais) sont connus. Un comparateur dynamique à verrouillage, par exemple le comparateur dynamique à verrouillage illustré sur la page internet wikipedia anglaise relative aux comparateurs, comprend typiquement deux inverseurs en contre réaction dont les sorties sont initialisées à un niveau haut lors d'une phase préliminaire, et une paire différentielle reliant les inverseurs à la masse, les deux transistors d'entrée de la paire différentielle recevant les deux signaux à comparer. Ainsi, le signal de plus forte valeur reçu par les transistors d'entrée de la paire différentielle induit un courant plus important dans l'inverseur correspondant, ce qui entraine un basculement plus rapide de la sortie de cet inverseur au niveau bas, et le maintien au niveau haut de la sortie de l'autre inverseur.

Toutefois, dans un comparateur dynamique à verrouillage, les dispersions de fabrication entre les transistors, en particulier entre les transistors d'entrée de la paire différentielle, conduisent à des erreurs de comparaison, donc à des erreurs de quantification lorsque le comparateur est mis en oeuvre dans un convertisseur analogique-numérique à approximations successives. De plus, la capacité grille-drain de chacun des transistors d'entrée de la paire différentielle induit un appel de charges sur l'entrée du comparateur, qui dépend du basculement de l'inverseur du comparateur associé à ce transistor. Cet appel de charges, couramment appelé effet de rebond ("kick-back effect" en langue anglaise), pénalise la précision du comparateur, donc de la quantification d'un signal analogique lorsque le comparateur est mis en oeuvre dans un convertisseur analogique-numérique à approximations successives.

Parmi les comparateurs dynamiques, les comparateurs dynamiques de type à poursuite de front ("edge pursuit" en anglais) sont également connus.

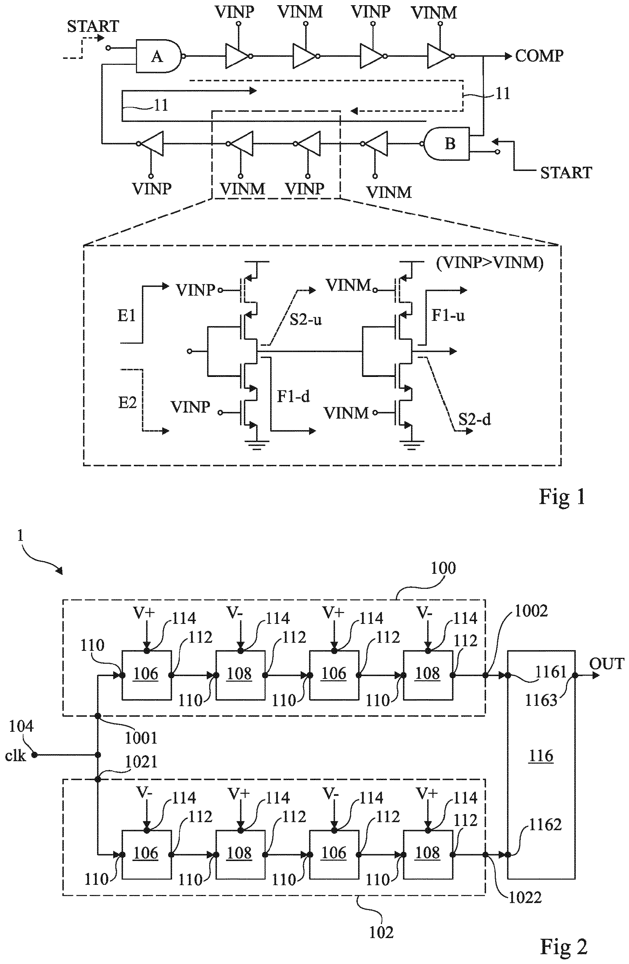

La figure 1 représente un exemple d'un comparateur dynamique de type à poursuite de front. Plus particulièrement, la figure 1 correspond à la figure 2 de l'article de M. Shim et al. intitulé " Edge-Pursuit Comparator: An Energy-Scalable Oscillator Collapse-Based Comparator With Application in a 74.1 dB SNDR and 20 kS/s 15 b SAR ADC" et publié dans IEEE Journal of Solid-State Circuits, Vol. 52, No. 4, Avril 2017.

Le comparateur de la figure 1 repose sur une structure élémentaire inverseuse composée d'un inverseur CMOS (Métal Oxyde Semiconducteur Complémentaire - "Complementary Métal Oxide Semiconductor" en langue anglaise) standard polarisé par un premier transistor MOS à canal N connecté entre la source du transistor MOS à canal N de l'inverseur et un potentiel de référence, et par un deuxième transistor MOS à canal P connecté entre la source du transistor MOS à canal P de l'inverseur et un potentiel d'alimentation. Les grilles de ces premier et deuxième transistors reçoivent une même tension de polarisation, choisie parmi deux tensions VINP et VINM comparées par le comparateur. En cascadant deux de ces structures élémentaires et en alternant la tension de polarisation VINP ou VINM des structures élémentaires cascadées, par exemple de sorte que la structure élémentaire en amont soit polarisée par la tension VINP et que la structure élémentaire en aval soit polarisée par la tension VINM, on constate les quatre cas suivants :
- front d'entrée montant ("E1" en figure 1) sur la structure élémentaire amont et VINP supérieure à VINM ("VINP > VINM" en figure 1) : descente rapide ("F1-d" en figure 1) de la sortie de la structure élémentaire amont et montée rapide ("F1-u" en figure 1) de la sortie de la structure élémentaire aval,
- front d'entrée montant sur la structure élémentaire amont et VINP inférieure à VINM : descente lente de la sortie de la structure élémentaire amont et montée lente de sortie de la structure élémentaire aval,
- front d'entrée ("E2" en figure 1) descendant sur la structure élémentaire amont et VINP supérieure à VINM ("VINP > VINM" en figure 1) : montée lente ("S2-d" en figure 1) de la sortie de la structure élémentaire amont et descente lente ("S2-u" en figure 1) de la sortie de la structure élémentaire aval, et
- front d'entrée descendant sur la structure élémentaire amont et VINP inférieure à VINM : montée rapide de la sortie de la structure élémentaire amont et descente rapide de la sortie de la structure élémentaire aval.

Le comparateur de la figure 1 comprend deux branches, comprenant chacune quatre structures élémentaires. Les deux branches sont rebouclées l'une sur l'autre par deux portes A et B de type NON-ET ("NAND" en langue anglaise), de manière à former une structure en anneau. Dans l'une des branches (la branche du haut en figure 1), les structures élémentaires sont alternativement polarisées par les tensions VINP puis VINM, alors que c'est l'inverse dans l'autre branche (la branche du bas en figure 1). En outre, l'entrée de chaque porte NON-ET qui n'est pas connecté à la sortie d'une branche reçoit un signal de synchronisation START.

Le fonctionnement de ce comparateur est le suivant. A l'état initial, le signal START est à l'état bas, d'où il résulte que la sortie de chaque porte A et B est à l'état haut et que la sortie de chaque branche, dont la sortie COMP du comparateur, sont à l'état haut également. Le passage à l'état haut du signal START, c'est-à-dire un front montant sur le signal START, provoque le passage à l'état bas de la sortie de chaque porte A et B, c'est-à-dire qu'un front descendant est fourni à la structure en anneau du comparateur par chacune des portes A et B. Ces deux fronts vont se propager à des vitesses différentes dans l'anneau, qui dépendent des tensions de polarisation VINP et VINM. Les deux fronts se propagent alors dans l'anneau (flèche 11 en figure 1) du comparateur jusqu'à ce que le front rapide rejoigne, ou rattrape, le front lent, ce qui résulte en une stabilisation des sorties des structures élémentaires des deux branches, des sorties des portes A et B, et de la sortie COMP du comparateur. Par exemple, dans la configuration de la figure 1, la sortie COMP se stabilise au niveau haut lorsque la tension VINP est supérieure à la tension VINM, et au niveau bas lorsque la tension VINP est inférieure à la tension VINM.

Dans un comparateur de type à poursuite de front, la séquence de transitions rapides sur les deux branches tend à moyenner l'effet de rebond. Cela permet de diminuer l'influence négative de cet effet de rebond par rapport au cas d'un comparateur dynamique à verrouillage. De manière similaire, les erreurs de comparaison induites par les dispersions de fabrication, ainsi que le bruit temporel, sont réduits par rapport à un comparateur dynamique à verrouillage. Plus exactement, plus le nombre de structures élémentaires par branche augmente, plus ces erreurs de comparaison et ce bruit temporel sont lissés.

Toutefois, un inconvénient du comparateur de la figure 1 est que le temps de stabilisation de son anneau, donc de sa sortie COMP, augmente avec la diminution de l'écart entre les tensions VINP et VINM qui sont comparées. L'augmentation du temps de stabilisation n'est pas souhaitable, notamment car elle induit une augmentation de la consommation.

### Résumé de l'invention

Il existe un besoin de pallier tout ou partie des inconvénients des comparateurs dynamiques connus.

Par exemple, il existe un besoin de pallier tout ou partie des inconvénients des comparateurs dynamiques connus décrits ci-dessus.

Un mode de réalisation pallie tout ou partie des inconvénients des comparateurs dynamiques connus.

Par exemple, un mode de réalisation pallie tout ou partie des inconvénients des comparateurs dynamiques connus décrits ci-dessus.

L'invention est définie par le contenu de la revendication 1 et prévoit un comparateur dynamique d'une première tension et d'une deuxième tension, comprenant des première et deuxième branches comportant chacune une même succession de premières et deuxièmes portes logiques alternées en série entre un premier noeud et une sortie de ladite branche, dans lequel :
chaque branche débute par une première porte,
chacune des premières et deuxièmes portes a un deuxième noeud configuré pour recevoir une tension de polarisation,
le deuxième noeud de chaque première porte de la première branche et de chaque deuxième porte de la deuxième branche reçoit la première tension(V+) et le deuxième noeud de chaque deuxième porte de la première branche et de chaque première porte de la deuxième branche recevant la deuxième tension, de sorte qu'un front sur le premier noeud se propage dans les première et deuxième branches à des vitesses déterminées par les première et deuxième tensions, et
un ordre d'arrivée des fronts propagés par les première et deuxième branches, sur les sorties desdites branches, détermine un résultat d'une comparaison des première et deuxième tensions.

Selon un mode de réalisation, chacune des premières et deuxièmes portes met en oeuvre une fonction inverseuse.

Selon un mode de réalisation, le front sur le premier noeud est un front montant, la tension sur le deuxième noeud de chaque première porte déterminant une vitesse de commutation à l'état bas de ladite porte, et la tension sur le deuxième noeud de chaque deuxième porte déterminant une vitesse de commutation à l'état haut de ladite porte, ou, selon un autre mode de réalisation, le front sur le premier noeud est un front descendant, la tension sur le deuxième noeud de chaque première porte déterminant une vitesse de commutation à l'état haut de ladite porte, et la tension sur le deuxième noeud de chaque deuxième porte déterminant une vitesse de commutation à l'état bas de ladite porte.

Selon un mode de réalisation, chacune des premières et deuxièmes portes comprend :
au moins un premier transistor MOS configuré pour commuter de ladite porte à l'état haut lorsque ladite porte reçoit un front montant ; et
au moins un deuxième transistor MOS configuré pour commuter ladite porte à l'état bas lorsque ladite porte reçoit un front montant, et, en outre :
   ledit au moins un premier transistor de chaque première porte est polarisé à partir de la tension sur le deuxième noeud de ladite porte et ledit au moins un deuxième transistor de chaque deuxième porte est polarisé à partir de la tension sur le deuxième noeud de ladite porte, lorsque le front sur le premier noeud est un front montant, ou
   ledit au moins un deuxième transistor de chaque première porte est polarisé à partir de la tension sur le deuxième noeud de ladite porte et ledit au moins un premier transistor de chaque deuxième porte est polarisé à partir de la tension sur le deuxième noeud de ladite porte, lorsque le front sur le premier noeud est un front descendant.

Selon un mode de réalisation, chacune des premières et deuxièmes portes comprend un troisième transistor MOS ayant une grille connectée au deuxième noeud de ladite porte, le troisième transistor de chaque première porte étant en série avec ledit au moins un premier transistor lorsque le front sur le premier noeud est un front descendant, ou en série avec ledit au moins un deuxième transistor lorsque le front sur le premier noeud est un front montant, et le troisième transistor de chaque deuxième porte étant en série avec ledit au moins un premier transistor lorsque le front sur le premier noeud est un front montant, ou en série avec ledit au moins un deuxième transistor lorsque le front sur le premier noeud est un front descendant.

Selon un mode de réalisation, les premier(s) et deuxième(s) transistors de chaque première et deuxième portes sont mis en oeuvre sur semiconducteur sur isolant, éventuellement sur semiconducteur sur isolant complètement déplété, et, en outre :
une grille arrière de chaque premier transistor de chaque première porte est connectée au deuxième noeud de ladite première porte et une grille arrière de chaque deuxième transistor de chaque deuxième porte est connectée au deuxième noeud de ladite deuxième porte quand le front sur le premier noeud est un front descendant ; ou
une grille arrière de chaque deuxième transistor de chaque première porte est connectée au deuxième noeud de ladite première porte et une grille arrière de chaque premier transistor de chaque deuxième porte est connectée au deuxième noeud de ladite deuxième porte quand le front sur le premier noeud est un front montant.

Selon un mode de réalisation, chacune des premières et deuxièmes portes comprend un unique premier transistor et un unique deuxième transistor.

Selon un mode de réalisation :
chaque première porte comprend :
   - un premier transistor MOS reliant une sortie de ladite porte à un troisième noeud ; et
   - un deuxième transistor en série avec un troisième transistor ou un ensemble de troisièmes transistors entre la sortie de ladite porte et un quatrième noeud, chaque troisième transistor ayant une grille connectée à une entrée de ladite porte, et chaque troisième transistor étant polarisé à partir de la tension sur le deuxième noeud de la porte ;
chaque deuxième porte comprend :
   - un quatrième transistor reliant une sortie de ladite porte au quatrième noeud ; et
   - un cinquième transistor en série avec un sixième transistor ou un ensemble de sixièmes transistors entre la sortie de ladite porte et le troisième noeud, chaque sixième transistor ayant une grille connectée à une entrée de ladite porte, et chaque sixième transistor étant polarisé à partir de la tension sur le deuxième noeud de la porte ;
les premier et quatrième transistors sont configurés pour être à l'état passant lorsqu'un premier signal est actif, et les deuxième et cinquième transistors sont configurés pour être à l'état bloqué lorsqu'un deuxième signal est actif ; et le troisième noeud est l'un d'un noeud configuré pour recevoir une tension d'alimentation et d'un noeud configuré pour recevoir une tension de référence, le quatrième noeud étant l'autre desdits noeuds.

Selon un mode de réalisation :
chaque première porte comprend un septième transistor MOS ayant une grille connectée au deuxième noeud de ladite première porte, le septième transistor étant en série avec le deuxième transistor entre le quatrième noeud et la sortie de ladite première porte ; et
chaque deuxième porte comprend un huitième transistor MOS ayant une grille connectée au deuxième noeud de ladite deuxième porte, le huitième transistor étant en série avec le cinquième transistor entre le troisième noeud et la sortie de ladite deuxième porte.

Selon un mode de réalisation :
chaque troisième transistor de chaque première porte est mis en oeuvre sur semiconducteur sur isolant, éventuellement sur semiconducteur sur isolant complètement déplété, et comprend une grille arrière connectée au deuxième noeud de ladite porte ; et
chaque cinquième transistor de chaque deuxième porte est mis en en oeuvre sur semiconducteur sur isolant, éventuellement sur semiconducteur sur isolant complètement déplété, et comprend une grille arrière connectée au deuxième noeud de ladite porte.

Selon un mode de réalisation, chaque première porte comprend un seul troisième transistor et chaque deuxième porte comprend un seul cinquième transistor.

Selon un mode de réalisation, le comparateur comprend en outre un circuit de commande configuré pour :
commuter le premier signal à l'état actif puis le deuxième signal à l'état actif pendant une phase d'initialisation préalable à une fourniture dudit front sur le premier noeud ; et
commuter les premier et deuxième signaux à un état inactif à la fin de la phase d'initialisation.

Selon un mode de réalisation :
le front sur le premier noeud est un front montant, le troisième noeud étant le noeud d'application de la tension d'alimentation et le quatrième noeud étant le noeud d'application de la tension de référence ; ou
le front sur le premier noeud est un front descendant, le troisième noeud étant le noeud d'application de la tension de référence et le quatrième noeud étant le noeud d'application de la tension d'alimentation.

Selon un mode de réalisation, le comparateur comprend en outre un circuit de mémorisation comprenant une première entrée connectée à la sortie de la première branche, une deuxième entrée connectée à la sortie de la deuxième branche, et une sortie déterminée par l'ordre d'arrivée, sur les première et deuxième entrées, des fronts propagés par les première et deuxième branches, le circuit de mémorisation comprenant, par exemple :
- deux portes NON-ET rebouclées l'une sur l'autre, l'une des deux portes ayant une entrée connectée à la première entrée dudit circuit et l'autre des deux portes ayant une entrée connectée à la deuxième entrée dudit circuit ; ou
- deux portes NON-OU rebouclées l'une sur l'autre, l'une des deux portes ayant une entrée connectée à la première entrée dudit circuit et l'autre des deux portes ayant une entrée connectée à la deuxième entrée dudit circuit ; ou
- une bascule de type D.

Un autre mode de réalisation prévoit un convertisseur analogique numérique comprenant un comparateur tel que décrit.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1, décrite précédemment, représente un exemple d'un comparateur dynamique du type à poursuite de front ;
la figure 2 représente, de manière très schématique et sous la forme de blocs, un exemple d'un comparateur dynamique selon un mode de réalisation ;
la figure 3 représente un exemple de deux portes du comparateur de la figure 2 selon un mode de réalisation ;
la figure 4 représente un exemple de deux portes du comparateur de la figure 2 selon une variante de réalisation ;
la figure 5 représente un exemple de deux portes du comparateur de la figure 2 selon un autre mode de réalisation ; et
la figure 6 représente un exemple de deux portes du comparateur de la figure 2 selon une autre variante de réalisation ;
la figure 7 représente un exemple d'une variante de réalisation du comparateur de la figure 2 ; .
la figure 8 représente un exemple d'une structure élémentaire mise en oeuvre à partir de deux portes du type de celle de la figure 5 ; et
la figure 9 représente un autre exemple d'une structure élémentaire mise en oeuvre à partir de deux portes du type de celles de la figure 5.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les circuits électroniques usuels dans lesquels un comparateur dynamique est mis en oeuvre n'ont pas été détaillés, les modes de réalisation décrits étant compatibles avec ces circuits usuels.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Dans la suite de la description, dans une branche de portes logiques en série, on considère qu'une première porte logique de la branche précède, ou est en amont, d'une deuxième porte logique de la branche, lorsqu'un front se propageant dans la branche est d'abord propagé par, ou à travers, la première porte puis par, ou à travers, la deuxième porte, et, à l'inverse, qu'une première porte logique de la branche suit, ou est en avale, d'une deuxième porte logique de la branche lorsqu'un front se propageant dans la branche est d'abord propagé par, ou à travers, la deuxième porte puis par, ou à travers, la première porte. Dit autrement, les termes "amont", "avale", "précédente" et "suivante" appliqués aux portes d'une branche sont définis par rapport au sens de propagation des fronts dans ladite branche.

Dans la suite de la description, un front, ou une transition binaire, peut être de deux types ou sens, à savoir le type montant et le type descendant. Un front de type montant, respectivement descendant, sera plus généralement appelé front montant, respectivement front descendant.

Dans la suite de la description, on appelle porte logique une porte, ou un circuit, purement combinatoire, c'est-à-dire dépourvue de fonction de mémorisation.

La présente demande propose un comparateur dynamique de type "à course de front" ("edge race" en anglais), dans lequel un front est fourni à deux branches concurrentes comprenant chacune une même succession de portes logiques en série, de sorte que ce front soit propagé dans chacune des deux branches. Les portes d'une branche sont polarisées alternativement à partir d'une première tension et d'une deuxième tension à comparer à la première tension, et les portes de l'autre branche sont polarisées de manière complémentaire, c'est-à-dire alternativement à partir de la deuxième tension et de la première tension. Du fait que chacune des première et deuxième tensions détermine les vitesses de propagation d'un front dans chaque porte qu'elle polarise, l'ordre d'arrivée du front propagé par chacune des branches indique si la première tension est ou non supérieure à la deuxième tension. Ce résultat de comparaison des première et deuxième tension peut être mémorisé en prévoyant un circuit de mémorisation connecté aux sorties des deux branches.

La figure 2 représente, de manière schématique et sous la forme de blocs, un mode de réalisation d'un tel comparateur 1. Le comparateur 1 est configuré pour comparer une tension V+ à une tension V-.

Le comparateur 1 comprend deux branches 100 et 102, délimitées par des traits en pointillé en figure 2. Les branches 100, 102 sont configurées pour propager, de manière concurrente, c'est-à-dire en parallèle, un front reçu sur un noeud 104 du comparateur 1. Ainsi, la branche 100, respectivement 102, comprend une entrée 1001, respectivement 1021, reliée, de préférence connectée, au noeud 104. A titre d'exemple, le signal reçu par le noeud 104 est un signal de synchronisation, par exemple un signal d'horloge clk.

Chacune des branches 100 et 102 comprend une même succession de portes logiques 106 et 108 alternées et connectées en série. Les portes 106 et 108 de la branche 100, respectivement 102, sont connectées en série, ou en cascade, entre l'entrée 1001, respectivement 1021, et une sortie 1002, respectivement 1022, de la branche. Chaque branche 100, 102 débute par une porte 106. Dit autrement, la première porte de chaque branche 100, 102 est une porte 106.

Chaque porte 106, 108, comprend une entrée 110, et une sortie 112. Chaque porte 106, 108 est configurée pour recevoir un front à propager sur son entrée 110, dite entrée de donnée, et pour propager ce front sur sa sortie 112. Plus particulièrement, lorsqu'elle propage un front, chaque porte 106, 108 est configurée pour que le front fourni par sa sortie 112 soit de type, ou de sens, opposé à celui du front reçu par son entrée 110. Dit autrement, chaque porte 106, 108 met en oeuvre une fonction inverseuse entre son entrée 110 et sa sortie 112.

Dans chaque branche 100, 102, l'entrée de donnée 110 de chaque porte 106, 108 est connectée à la sortie 112 de la porte 108, 106 immédiatement précédente de la branche, ou à l'entrée 1001, 1021 de la branche 100, 102 lorsque cette porte est la première porte 106 de la branche.

De préférence, chaque branche 100, 102 comporte autant de portes 106 que de portes 108, comme c'est notamment le cas en figure 2, bien que les modes de réalisation décrits ne se limitent pas à cet exemple.

Dans l'exemple particulier de la figure 2, chaque branche 100, 102 comporte deux portes 106 et deux portes 108. Toutefois, le nombre de portes 106 et/ou le nombre de porte 108 par branche peuvent être différents de deux, par exemple être supérieur à deux, ou être égal à 1.

Chaque porte 106, 108 comprend un noeud 114, dit entrée de polarisation, configuré pour recevoir une tension de polarisation de la porte. Chaque porte 106, 108 est configurée pour que la vitesse de propagation d'un front par cette porte soit déterminée par la tension de polarisation qu'elle reçoit sur son entrée de polarisation 114.

Selon un mode de réalisation, dans lequel le front sur le noeud 104 déclenchant une comparaison des tensions V+ et V- est un front montant, la tension V+ ou V- sur le noeud 114 de chaque porte 106 détermine une vitesse de commutation à l'état bas de cette porte 106, et la tension sur le noeud 114 de chaque porte 108 détermine une vitesse de commutation à l'état haut de cette porte. Dans une variante de réalisation, le front sur le noeud 104 déclenchant une comparaison est un front descendant, la tension sur le noeud 114 de chaque porte 106 détermine une vitesse de commutation à l'état haut de cette porte, et la tension sur le noeud 114 de chaque porte 108 détermine une vitesse de commutation à l'état bas de cette porte.

Les portes 106, 108 d'une première branche, la branche 100 dans l'exemple de la figure 2, reçoivent alternativement la tension V+ et la tension V- sur leurs noeuds 114 respectifs, les portes 106, 108 de la deuxième branche, la branche 102 dans l'exemple de la figure 2, étant polarisées de manière complémentaire aux portes 106, 108 de la première branche, c'est-à-dire que les portes 106, 108 de la deuxième branche reçoivent alternativement la tension V- et la tension V+ sur leurs noeuds 114 respectifs. Dit autrement, dans l'exemple de la figure 2, le noeud 114 de chaque porte 106 de la branche 100 et de chaque porte 108 de la branche 102 reçoit la tension V+, et le noeud 114 de chaque porte 108 de la branche 100 et de chaque porte 106 de la branche 102 reçoit la tension V-.

Ainsi, lorsque les tensions V+ et V- sont différentes, le front se propage à des vitesses différentes dans les branches 100 et 102. Cela résulte du fait que la vitesse de propagation d'un front par chaque porte 106, 108 dépend de la tension V+ ou V- qu'elle reçoit sur son noeud 114, et que les portes de la branche 100 sont polarisées de manière complémentaire à celles de la branche 102.

Du fait qu'une différence entre les tensions V+ et V-à comparer entraîne une différence correspondante de vitesse de propagation entre les branches 100 et 102, l'ordre d'arrivée du front propagé par chaque branche 100, 102, sur la sortie 1001, 1021 de cette branche, permet de déterminer si la tension V+ est ou non supérieure à la tension V-.

Selon un mode de réalisation, le comparateur 1 comprend un circuit de mémorisation 116. Le circuit 116 comprend une entrée 1161 reliée, de préférence connectée, à la sortie 1002 de la branche 102, et une entrée 1162 reliée, de préférence connectée, à la sortie 1022 de la branche 102. Le circuit 116 comprend une sortie 1163. La sortie 1163, c'est-à-dire plus exactement son état binaire, est déterminée par l'ordre d'arrivée, sur les entrées 1161 et 1662, des fronts propagés par les branches respectives 100 et 102. Dit autrement, la sortie 1163 fournit un signal binaire OUT dont un premier état binaire indique que le front propagé par la branche 100 a atteint l'entrée 1161 avant que le front propagé par la branche 100 ait atteint l'entrée 1162, et dont un deuxième état binaire indique que le front propagé par la branche 100 a atteint l'entrée 1161 après que le front propagé par la branche 100 ait atteint l'entrée 1162.

A titre d'exemple, le circuit 116 peut comprend deux portes NON-ET ("NAND" en anglais) rebouclées l'une sur l'autre, une des deux portes ayant une entrée connectée à l'entrée 1161 du circuit 116, et l'autre des deux portes ayant une entrée connectée à l'entrée 1162 du circuit 116. La sortie 1163 correspond alors à la sortie de l'une ou l'autre des deux portes. Ce circuit 116 est, par exemple, adapté au cas où le front propagé par chaque branche 100, 102 est de type montant lorsqu'il atteint l'entrée 1161, 1162 correspondante du circuit 116.

Selon un autre exemple, le circuit 116 comprend deux portes NON-OU ("NOR" en anglais) rebouclées l'une sur l'autre, une des deux portes ayant une entrée connectée à l'entrée 1161 du circuit 116, et l'autre des deux portes ayant une entrée connectée à l'entrée 1162 du circuit 116. La sortie 1163 correspond alors à la sortie de l'une ou l'autre des deux portes. Ce circuit 116 est, par exemple, adapté au cas où le front propagé par chaque branche 100, 102 est de type descendant lorsqu'il atteint l'entrée 1161, 1162 correspondante du circuit 116.

Selon encore un autre exemple, le circuit 116 comprend une bascule de type D ("D-flip flop " en anglais) ayant une entrée D de donnée reliée, de préférence connectée, à l'une des entrées 1161 et 1162, et une entrée C de synchronisation reliée, de préférence connectée, à l'autre à l'une des entrées 1161 et 1162. Dans le cas où les fronts propagés reçus sur les entrées 1161 et 1662 sont montants, respectivement descendants, l'entrée C est active sur front montant, respectivement descendant. La sortie 1163 correspond alors à une sortie de la bascule D.

La personne du métier saura prévoir d'autres exemples de circuit de mémorisation 116.

Un avantage du comparateur 1 par rapport à un comparateur du type de celui de figure 1 comprenant autant de structures élémentaires inverseuses que le comparateur 1 comprend de portes 106, 108, est que le résultat de la comparaison des tensions V+ et V- est obtenu plus rapidement avec le comparateur 1. En effet, les branches 100 et 102 du comparateur 1 ne sont pas rebouclées l'une sur l'autre comme c'est le cas en figure 1. Il en résulte que le nombre de portes 106, 108 traversées par un front dans le comparateur 1 avant d'obtenir le résultat de la comparaison de la tension V+ à la tension V-, est inférieur au nombre de structures élémentaires inverseuses traversées par un front dans le comparateur du type de celui de la figure 1 avant d'obtenir le résultat de la comparaison de la tension VINP avec la tension VINM. Dit autrement, le temps de réponse du comparateur 1 est inférieur au temps de réponse du comparateur de la figure 1. Cela est d'autant plus vrai que les tensions à comparer sont proches l'une de l'autre.

En outre, dans le comparateur 1, le type de front, à savoir montant ou descendant, qui est fourni au noeud 104 est généralement connu, d'où il résulte que le type de front reçu par l'entrée 110 de chacune des portes 106 et 108 du comparateur 1 est connu. Comme cela sera décrit ci-dessous, on tire parti de cette connaissance à priori du type de front reçu par chaque porte pour la mise en oeuvre de ces dernières.

Divers modes de réalisation et variante de réalisation des portes 106 et 108 vont maintenant être décrits. De préférence, toutes les portes 106 sont mises en oeuvre de la même façon, exception faite éventuellement de la tension V+ ou V- qu'elles reçoivent sur leurs noeuds 114, les portes 108 étant de préférence toutes mises en oeuvre de la même façon, exception faite éventuellement de la tension V+ ou V- qu'elles reçoivent sur leurs noeuds 114.

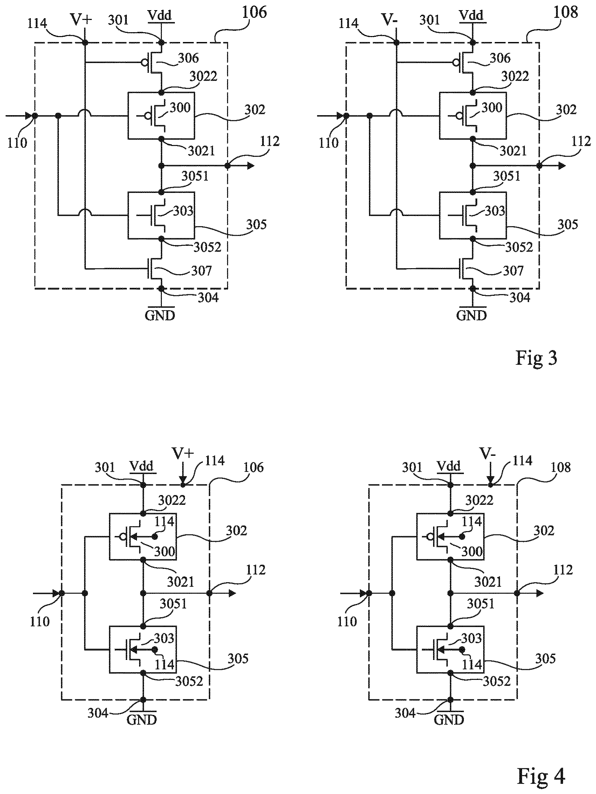

La figure 3 représente, de manière schématique, un mode de réalisation d'une porte 106 (à gauche sur la figure 3) et d'une porte 108 (à droite sur la figure 3) du comparateur 1 de la figure 2. Dans l'exemple de la figure 3, les portes 106 et 108 appartiennent à la branche 100 du comparateur 1, et la tension V+, respectivement V-, est reçue par le noeud 114 de la porte 106, respectivement 108. Dans un autre exemple non illustré, les portes 106 et 108 appartiennent à la branche 102, et la tension V-, respectivement V+, est reçue par le noeud 114 de la porte 106, respectivement 108.

Chaque porte 106, 108 comprend au moins un transistor MOS 300, de préférence à canal P, configuré pour commuter la porte, c'est-à-dire sa sortie 112, à l'état haut lorsque la porte, c'est-à-dire son entrée 110, reçoit un front descendant. A titre d'exemple, le ou les transistors 300 relient la sortie 112 de la porte à un noeud 301 d'application d'une tension d'alimentation Vdd.

En figure 3, dans chaque porte 106, 108, le transistor 300, ou l'ensemble des transistors 300 lorsque la porte comprend plusieurs transistors 300, est représenté schématiquement sous la forme d'un bloc 302. A titre d'exemple, lorsque la porte comprend plusieurs transistors MOS 300, ces transistors sont associés en série et/ou en parallèle entre un noeud 3021 relié, par exemple connecté, à la sortie 112, et un noeud 3022 relié au noeud 301.

Chaque porte 106, 108 comprend en outre au moins un transistor MOS 303, de préférence à canal N, configuré pour commuter la porte à l'état bas lorsque la porte reçoit un front montant. A titre d'exemple, le ou les transistors 303 relient la sortie 112 de la porte à un noeud 304 d'application d'une tension de référence GND, par exemple la masse.

En figure 3, dans chaque porte 106, 108, le transistor 303, ou l'ensemble des transistors 303 lorsque la porte comprend plusieurs transistors 303, est représenté schématiquement sous la forme d'un bloc 305. A titre d'exemple, lorsque la porte comprend plusieurs transistors MOS 303, ces transistors sont associés en série et/ou en parallèle entre un noeud 3051 relié, par exemple connecté, à la sortie 112, et un noeud 3052 relié au noeud 304.

Dans chaque porte 106, 108, une grille de chaque transistor 300, 303 est, de préférence, connectée à l'entrée 110 de la porte.

Selon un premier mode de réalisation, le front appliqué sur le noeud 104 (figure 2) pour déclencher une comparaison des tensions V+ et V- est un front montant. Dans ce premier mode de réalisation, le ou les transistors 303 de la porte 106 sont alors polarisés à partir de la tension sur le noeud 114 de la porte 106, et le ou les transistors 300 de la porte 108 sont polarisés à partir de la tension sur le noeud 114 de la porte 108.

Plus particulièrement, dans ce premier mode de réalisation, la porte 106 comprend un transistor MOS 307, de préférence à canal N, pour polariser le ou les transistors 303 à partir de la tension sur le noeud 114. Le transistor 307 a une grille connectée au noeud 114 de la porte 106. En outre, le transistor 307 est en série avec le transistor 303, ou l'ensemble des transistors 303, de la porte 106, entre le noeud 304 et la sortie 112 de la porte 106. De préférence, le transistor 307 a une borne de conduction, par exemple sa source, reliée, de préférence connectée, au noeud 304, et une autre borne de conduction, par exemple son drain, reliée, de préférence connectée, au noeud 3052. Dans un autre exemple non illustré, le transistor 307 est disposé entre le bloc 305 et la sortie 112. Toutefois, par rapport à l'exemple où le transistor 307 est disposé entre le noeud 304 et le bloc 305, la sensibilité à l'effet rebond est plus importante dans l'exemple où le transistor 307 est disposé entre le bloc 305 et la sortie 112.

En outre, dans ce premier mode de réalisation, la porte 108 comprend un transistor MOS 306, de préférence à canal P, pour polariser le ou les transistors 300 de la porte 108 à partir de la tension sur le noeud 114 de porte 108. Le transistor 306 a une grille connectée au noeud 114 de la porte 108. En outre, le transistor 306 est en série avec le transistor 300, ou l'ensemble des transistors 300, de la porte 108, entre le noeud 301 et la sortie 112 de la porte 108. De préférence, le transistor 306 a une borne de conduction, par exemple sa source, reliée, de préférence connectée, au noeud 301, et une autre borne de conduction, par exemple son drain, reliée, de préférence connectée, au noeud 3022. Dans un autre exemple non illustré, le transistor 306 est disposé entre le bloc 302 et la sortie 112. Toutefois, par rapport à l'exemple où le transistor 306 est disposé entre le noeud 301 et le bloc 302, la sensibilité à l'effet rebond est plus importante dans l'exemple où le transistor 306 est disposé entre le bloc 302 et la sortie 112.

Selon un premier exemple de mise en oeuvre du premier mode de réalisation, comme cela est illustré par la figure 3, le ou les transistors 300 de la porte 106 sont également polarisés à partir de la tension sur le noeud 114 de la porte 106, et le ou les transistors 303 de la porte 108 sont également polarisés à partir de la tension sur le noeud 114 de la porte 108. La porte 106 comprend alors, comme la porte 108, un transistor 306, de préférence à canal P, ayant une grille connectée au noeud 114 de la porte 108, et étant en série avec le transistor 300, ou l'ensemble des transistors 300, de la porte 106, entre le noeud 301 et la sortie 112 de la porte 106. En outre, la porte 108 comprend alors, comme la porte 106, un transistor 307, de préférence à canal N, ayant une grille connectée au noeud 114 de la porte 108, et étant en série avec le transistor 303 ou l'ensemble des transistors 303 de la porte 108, entre le noeud 304 et la sortie 112 de la porte 108.

Selon un deuxième exemple, non illustré, de mise en oeuvre du premier mode de réalisation, le ou les transistors 300, respectivement 303, de la porte 106, respectivement 108, ne sont pas polarisés à partir des tensions V+ et V-. Dans ce deuxième exemple, le transistor 306 de la porte 106 et le transistor 307 de la porte 108 peuvent être omis.

Selon un troisième exemple, non illustré, de mise en oeuvre du premier mode de réalisation, lorsque le ou les transistors 303 de la porte 106 sont polarisés à partir de la tension V+, respectivement V-, reçue par le noeud 114 de la porte 106, le ou les transistors 300 de la porte 106 sont polarisés à partir de la tension V-, respectivement V+, reçue par un noeud de polarisation supplémentaire de la porte 106. De manière similaire, lorsque le ou les transistors 300 de la porte 108 sont polarisés à partir de la tension V-, respectivement V+, reçue par le noeud 114 de la porte 108, le ou les transistors 303 de la porte 108 sont polarisés à partir de la tension V+, respectivement V-, reçue par un noeud de polarisation supplémentaire de la porte 108. Dans ce troisième exemple, la porte 106 comprend le transistor 306, mais, à la différence de ce qui est illustré en figure 3, sa grille est connectée au noeud de polarisation supplémentaire de la porte 106, et la porte 108 comprend le transistor 307, mais, à la différence de ce qui est illustré en figure 3, sa grille est connectée au noeud de polarisation supplémentaire de la porte 108.

On a considéré ci-dessus des exemples de mise en oeuvre d'un premier mode de réalisation où le front appliqué sur le noeud 104 (figure 2) pour déclencher une comparaison des tensions V+ et V- est un front montant. On considère maintenant un deuxième mode de réalisation dans lequel le front appliqué sur le noeud 104 (figure 2) pour déclencher une comparaison des tensions V+ et V- est un front descendant. Dans ce deuxième mode de réalisation, le ou les transistors 300 de la porte 106 sont alors polarisés à partir de la tension sur le noeud 114 de la porte 106, et le ou les transistors 303 de la porte 108 sont polarisés à partir de la tension sur le noeud 114 de la porte 108.

Dans ce deuxième mode de réalisation, la porte 106 comprend alors le transistor 306 en série avec le ou les transistors 300, entre le noeud 301 et la sortie 112 de la porte 106, la porte 108 comprenant le transistor 307 en série avec le ou les transistors 303, entre le noeud 304 et la sortie 112 de la porte 108. La grille du transistor 306 de la porte 106 est connectée au noeud 114 de la porte 106, la grille du transistor 307 de la porte 108 étant connectée au noeud 114 de la porte 108.

Selon un premier exemple de mise en oeuvre du deuxième mode de réalisation, illustré par la figure 3, le ou les transistors 303 de la porte 106 sont également polarisés à partir de la tension sur le noeud 114 de la porte 106, et le ou les transistors 300 de la porte 108 sont également polarisés à partir de la tension sur le noeud 114 de la porte 108. La porte 106 comprend alors le transistor 307, en série avec le ou les transistors 303 de la porte 106, entre le noeud 304 et la sortie 112 de la porte 106, la grille de ce transistor 307 étant connectée au noeud 114 de la porte 106. En outre, la porte 108 comprend alors le transistor 306, en série avec le ou les transistors 300 de la porte 108, entre le noeud 301 et la sortie 112 de la porte 108, la grille de ce transistor 306 étant connectée au noeud 114 de la porte 108.

Selon un deuxième exemple, non illustré, de mise en oeuvre du deuxième mode de réalisation, le ou les transistors 303, respectivement 300, de la porte 106, respectivement 108, ne sont pas polarisés à partir des tensions V+ et V-. Dans ce deuxième exemple, le transistor 307 de la porte 106 et le transistor 306 de la porte 108 peuvent être omis.

Selon un troisième exemple, non illustré, de mise en oeuvre du deuxième mode de réalisation, lorsque le ou les transistors 300 de la porte 106 sont polarisés à partir de la tension V+, respectivement V-, reçue par le noeud 114 de la porte 106, le ou les transistors 303 de la porte 106 sont polarisés à partir de la tension V-, respectivement V+, reçue par un noeud de polarisation supplémentaire de la porte 106. De manière similaire, lorsque le ou les transistors 303 de la porte 108 sont polarisés à partir de la tension V-, respectivement V+, reçue par le noeud 114 de la porte 108, le ou les transistors 300 de la porte 108 sont polarisés à partir de la tension V+, respectivement V-, reçue par un noeud de polarisation supplémentaire de la porte 108. Dans ce troisième exemple, la porte 106 comporte le transistor 307, mais, à la différence de ce qui est illustré en figure 3, sa grille est connectée au noeud de polarisation supplémentaire de la porte 106, et la porte 108 comprend le transistor 306, mais, à la différence de ce qui est illustré en figure 3, sa grille est connectée au noeud de polarisation supplémentaire de la porte 108.

Dans les exemples de premier et deuxième modes de réalisation décrits ci-dessus en relation avec la figure 3, les transistors 300 et 303 sont par exemple mis en oeuvre à partir d'un substrat semiconducteur massif ("bulk" en anglais), à partir d'une structure de type semiconducteur sur isolant (SOI de l'anglais "Semiconductor On Insulator"), ou d'une structure de type semiconducteur sur isolant complètement déplétée (FDSOI de l'anglais "Fully Depleted Semiconductor On Insulator").

La figure 4 représente, de manière schématique, une variante de réalisation d'une porte 106 (à gauche en figure 4) et d'une porte 108 (à droite en figure 4) du comparateur 1 de la figure 2. On considère ici, à titre d'exemple, que ces portes 106 et 108 appartiennent à la branche 100 du comparateur 1, la tension V+, respectivement V-, étant alors reçue par le noeud 114 de la porte 106, respectivement 108. Dans un autre exemple non illustré, ces portes 106 et 108 appartiennent à la branche 102, et la tension V-, respectivement V+, est reçue par le noeud 114 de la porte 106, respectivement 108.

En figure 4, comme en figure 3, chaque porte 106, 108 comprend le ou les transistors 300 (bloc 302) et le ou les transistors 303 (bloc 305).

En figure 4, chaque transistor 300, 303 de chaque porte 106, 108 est mis en oeuvre à partir d'une structure SOI, de préférence à partir d'une structure de type FDSOI. Du fait que les transistors 300 et 303 sont mis en oeuvre sur SOI ou sur FDSOI, chacun de ces transistors 300 et 303 dispose d'une grille arrière ("back gate" en anglais) en plus de sa grille avant ("front gate" en anglais) qui est, par exemple, connectée à l'entrée 110 de la porte.

Selon une première variante de réalisation, le front appliqué sur le noeud 104 (figure 2) pour déclencher une comparaison des tensions V+ et V- est un front montant. Dans cette première variante de réalisation, le ou les transistors 303 de la porte 106 sont alors polarisés à partir de la tension sur le noeud 114 de la porte 106, et le ou les transistors 300 de la porte 108 sont polarisés à partir de la tension sur le noeud 114 de la porte 108. La grille arrière de chaque transistor 303 de la porte 106 est alors connectée au noeud 114 de la porte 106, la grille arrière de chaque transistor 300 de la porte 108 étant connectée au noeud 114 de la porte 108. En outre, dans cette première variante, les transistors 306 et 307 peuvent être omis comme cela est illustré par la figure 4. Il en résulte que les portes 106 et 108 de la figure 4 sont plus compactes que celles de la figure 3.

Selon un premier exemple de mise en oeuvre de la première variante de réalisation, illustré par la figure 4, le ou les transistors 300 de la porte 106 sont également polarisés à partir de la tension sur le noeud 114 de la porte 106, et le ou les transistors 303 de la porte 108 sont également polarisés à partir de la tension sur le noeud 114 de la porte 108. La grille arrière de chaque transistor 300 de la porte 106 est alors connectée au noeud 114 de la porte 106, la grille arrière de chaque transistor 303 de la porte 108 étant connectée au noeud 114 de la porte 108.

Selon un deuxième exemple, non illustré, de mise en oeuvre de la première variante de réalisation, le ou les transistors 300, respectivement 303, de la porte 106, respectivement 108, ne sont pas polarisés à partir des tensions V+ et V-. Dans ce deuxième exemple, la grille arrière de chaque transistor 300 de la porte 106 n'est pas connectée ou reliée au noeud 114 de la porte 106, et la grille arrière de chaque transistor 303 de la porte 108 n'est pas connectée ou reliée au noeud 114 de la porte 108.

Selon un troisième exemple, non illustré, de mise en oeuvre de la première variante de réalisation, lorsque le ou les transistors 303 de la porte 106 sont polarisés à partir de la tension V+, respectivement V-, reçue par le noeud 114 de la porte 106, le ou les transistors 300 de la porte 106 sont polarisés à partir de la tension V-, respectivement V+, reçue par un noeud de polarisation supplémentaire de la porte 106. De manière similaire, lorsque le ou les transistors 300 de la porte 108 sont polarisés à partir de la tension V-, respectivement V+, reçue par le noeud 114 de la porte 108, le ou les transistors 303 de la porte 108 sont polarisés à partir de la tension V+, respectivement V-, reçue par un noeud de polarisation supplémentaire de la porte 108. Dans ce troisième exemple, la grille arrière de chaque transistor 300 de la porte 106 est connectée au noeud de polarisation supplémentaire de la porte 106, et la grille arrière de chaque transistor 303 de la porte 108 est connectée au noeud de polarisation supplémentaire de la porte 108.

On a considéré ci-dessus des exemples de mises en oeuvre d'une première variante de réalisation où le front appliqué sur le noeud 104 (figure 2) pour déclencher une comparaison des tensions V+ et V- est un front montant. On considère maintenant une deuxième variante de réalisation dans laquelle le front appliqué sur le noeud 104 (figure 2) pour déclencher une comparaison des tensions V+ et V- est un front descendant. Dans cette deuxième variante de réalisation, le ou les transistors 300 de la porte 106 sont alors polarisés à partir de la tension sur le noeud 114 de la porte 106, et le ou les transistors 303 de la porte 108 sont polarisés à partir de la tension sur le noeud 114 de la porte 108. La grille arrière de chaque transistor 300 de la porte 106 est alors connectée au noeud 114 de la porte 106, la grille arrière de chaque transistor 303 de la porte 108 étant connectée au noeud 114 de la porte 108. En outre, dans cette deuxième variante, comme dans la première variante, les transistors 306 et 307 peuvent être omis. Il en résulte que les portes 106 et 108 de la figure 4 sont plus compactes que celles de la figure 3.

Selon un premier exemple de mise en oeuvre de la deuxième variante de réalisation, illustré par la figure 4, le ou les transistors 303 de la porte 106 sont également polarisés à partir de la tension sur le noeud 114 de la porte 106, et le ou les transistors 300 de la porte 108 sont également polarisés à partir de la tension sur le noeud 114 de la porte 108. La grille arrière de chaque transistor 303 de la porte 106 est alors connectée au noeud 114, la grille arrière de chaque transistor 300 de la porte 108 étant connectée au noeud 114 de la porte 108.

Selon un deuxième exemple, non illustré, de mise en oeuvre de la deuxième variante de réalisation, le ou les transistors 303, respectivement 300, de la porte 106, respectivement 108, ne sont pas polarisés à partir des tensions V+ et V-. Dans ce deuxième exemple, la grille arrière de chaque transistor 303 de la porte 106 n'est pas connectée ou reliée au noeud 114 de la porte 106, la grille arrière de chaque transistor 300 de la porte 108 n'étant pas connectée ou reliée au noeud 114 de la porte 108.

Selon un troisième exemple, non illustré, de mise en oeuvre de la deuxième variante de réalisation, lorsque le ou les transistors 300 de la porte 106 sont polarisés à partir de la tension V+, respectivement V-, reçue par le noeud 114 de la porte 106, le ou les transistors 303 de la porte 106 sont polarisés à partir de la tension V-, respectivement V+, reçue par un noeud de polarisation supplémentaire de la porte 106. De manière similaire, lorsque le ou les transistors 303 de la porte 108 sont polarisés à partir de la tension V-, respectivement V+, reçue par le noeud 114 de la porte 108, le ou les transistors 300 de la porte 108 sont polarisés à partir de la tension V+, respectivement V-, reçue par un noeud de polarisation supplémentaire de la porte 108. Dans ce cas, la grille arrière de chaque transistor 303 de la porte 106 est connectée au noeud de polarisation supplémentaire, la grille arrière de chaque transistor 300 de la porte 108 étant connectée au noeud de polarisation supplémentaire de la porte 108.

On a décrit ci-dessus, en relation avec la figure 3, des exemples de mises en oeuvre d'un premier et d'un deuxième modes de réalisation des portes 106 et 108, et, en relation avec la figure 4, des exemples de mises en oeuvre d'une première et d'une deuxième variantes de réalisation des portes 106 et 108. La personne du métier est en mesure de combiner les premier, deuxième et troisième exemples de mise en oeuvre du premier mode de réalisation avec, respectivement, les premier, deuxième et troisième exemples de mise en oeuvre de la première variante de réalisation, et de combiner les premier, deuxième et troisième exemples de mises en oeuvre du deuxième mode de réalisation avec, respectivement, les premier, deuxième et troisième exemples de mise en oeuvre de la deuxième variante de réalisation.

De préférence, dans les divers exemples des modes de réalisation et variantes décrits ci-dessus en relation avec la figure 3 et la figure 4, chaque porte 106, 108 comprend un unique transistor 300 et un unique transistor 303. Dans ce cas, dans chaque porte 106, 108, une borne de conduction, par exemple la source, du transistor 300 est reliée, de préférence connectée, au noeud 3022, une autre borne de conduction, par exemple le drain, du transistor 300 est reliée, de préférence connectée, au noeud 3021, une borne de conduction, par exemple la source, du transistor 303 est reliée, de préférence connectée, au noeud 3052, et une autre borne de conduction, par exemple le drain, du transistor 303 est reliée, de préférence connectée, au noeud 3051.

Des modes de réalisation d'un comparateur dynamique à course de front ("edge race dynamic comparator" en anglais) ont été décrits ci-dessus en relation avec la figure 2, la figure 3 et la figure 4.

Dans ces modes de réalisation et variantes, on a considéré que le type du front, à savoir montant ou descendant, qui est appliqué au noeud 104 pour déclencher une comparaison des tensions V+ et V- est connu à l'avance. Toutefois, dans le cas où ce n'est pas le cas, les portes 106 et 108 sont mises en oeuvre comme indiqué dans les premiers exemples de mises en oeuvre.

Il est proposé de tirer encore plus parti de cette connaissance à priori du type de front sur le noeud 104 pour modifier la structure des portes 106, 108 de chaque branche du comparateur afin de réduire la consommation du comparateur.

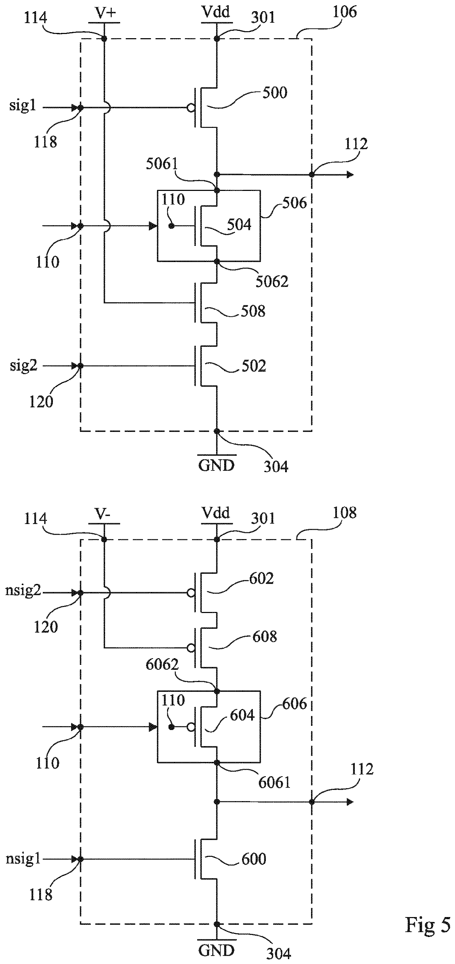

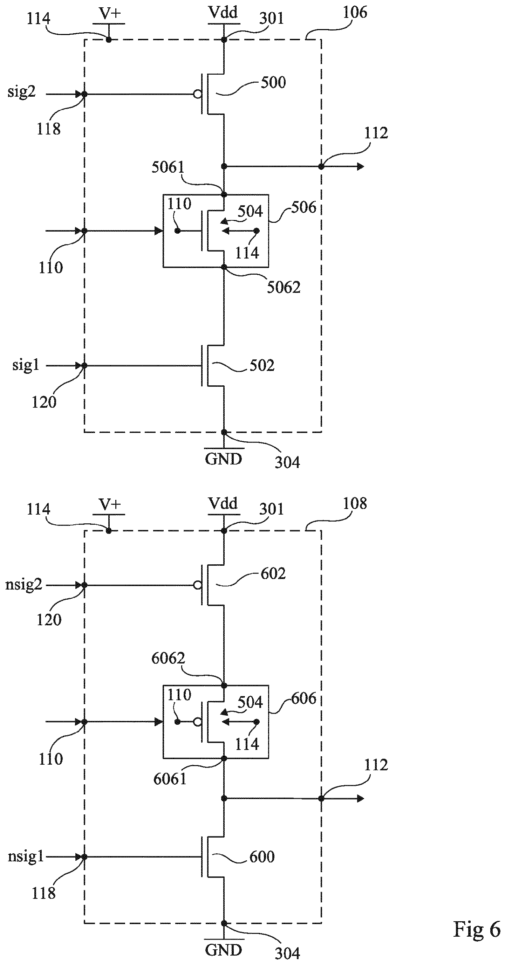

La figure 5 représente un exemple d'une porte 106 (en haut en figure 5) et d'une porte 108 (à bas en figure 6) du comparateur 1 de la figure 2, selon un mode de réalisation où l'on tire profit de la connaissance à priori du type de front sur le noeud 104 du comparateur. Plus particulièrement, la figure 5 illustre un troisième mode de réalisation dans lequel un front montant est appliqué au noeud 104 (figure 2) pour déclencher une phase de comparaison des tensions V+ et V-. Dans ce troisième mode de réalisation, lors de la phase de comparaison, la porte 106 reçoit un front montant sur son entrée 110 et la porte 108 reçoit un front descendant sur son entrée 110. Dans l'exemple de la figure 5, les portes 106 et 108 appartiennent à la branche 100 du comparateur 1, et la tension V+, respectivement V-, est reçue par le noeud 114 de la porte 106, respectivement 108. Dans un autre exemple non illustré, ces portes 106 et 108 appartiennent à la branche 102, et la tension V-, respectivement V+, est reçue par le noeud 114 de la porte 106, respectivement 108.

La porte 106 comprend un transistor MOS 500, par exemple à canal P, reliant la sortie 112 de la porte au noeud 301. A titre d'exemple, le transistor 500 a une borne de conduction, par exemple sa source, reliée, de préférence connectée, au noeud 301, et une autre borne de conduction, par exemple son drain, reliée, de préférence connectée à la sortie 112 de la porte.

Le transistor 500 est configuré pour être à l'état passant lorsqu'un signal sig1 est actif, c'est-à-dire lorsque le signal binaire sig1 est dans un état binaire correspondant à cet état actif. La porte 106 comprend donc une entrée 118, dite de commande, configurée pour recevoir un signal de commande du transistor 500, la grille du transistor 500 étant connectée à l'entrée 118 de la porte. A titre d'exemple, et comme cela est représenté en figure 5, lorsque l'état binaire du signal sig1 correspondant à l'état actif est l'état bas, et lorsque le transistor 500 est à canal P, l'entrée 118 reçoit le signal sig1.

La porte 106 comprend en outre un transistor MOS 502, et un transistor MOS 504 ou un ensemble de transistor MOS 504. En figure 5, le transistor 504, ou l'ensemble des transistors 504 lorsque la porte 106 comprend plusieurs transistors 504, est représenté schématiquement sous la forme d'un bloc 506.

A titre d'exemple, lorsque la porte 106 comprend plusieurs transistors MOS 504, ces transistors sont associés en série et/ou en parallèle entre un noeud 5061 relié, par exemple connecté, à la sortie 112, et un noeud 5062 relié au noeud 304. Selon un autre exemple, lorsque la porte 106 ne comprend qu'un seul transistor 504, celui-ci a une borne de conduction, par exemple sa source, reliée, de préférence connectée, au noeud 5062, et une autre borne de conduction, par exemple son drain, reliée, de préférence connectée, au noeud 5061.

Le transistor 502 est connecté en série avec le transistor 504 ou avec l'ensemble des transistors 504, entre la sortie 112 et le noeud 304 de la porte 106. La grille de chaque transistor 504 est connectée à l'entrée 110 de la porte. Les transistors 502 et 504 sont, par exemple à canal N. Le transistor 502 a par exemple une borne de conduction, par exemple sa source, reliée au noeud 304, et une autre borne de conduction, par exemple son drain, reliée au noeud 5062.

Le transistor 502 est configuré pour être à l'état bloqué lorsqu'un signal sig2 est actif, c'est-à-dire lorsque le signal binaire sig2 est dans un état binaire correspondant à cet état actif. La porte 106 comprend donc une entrée 120, dite de commande, configurée pour recevoir un signal de commande du transistor 502, la grille du transistor 502 étant connectée à l'entrée 120 de la porte. A titre d'exemple, et comme cela est représenté en figure 5, lorsque l'état binaire du signal sig2 correspondant à l'état actif est l'état bas, et lorsque le transistor 502 est à canal N, l'entrée 120 reçoit le signal sig2.

La porte 108 comprend un transistor MOS 600, par exemple à canal N, reliant la sortie 112 de la porte au noeud 304. Par exemple, le transistor 600 a une borne de conduction, par exemple sa source, reliée, de préférence connectée, au noeud 304, et une autre borne de conduction, par exemple son drain, reliée, de préférence connectée à la sortie 112 de la porte.

Le transistor 600 est configuré pour être à l'état passant lorsque le signal sig1 est actif. La porte 108 comprend donc, comme la porte 106, une entrée 118 de commande configurée pour recevoir un signal de commande du transistor 600, la grille du transistor 600 étant connectée à l'entrée 118 de la porte. A titre d'exemple, et comme cela est représenté en figure 5, lorsque l'état binaire du signal sig1 correspondant à l'état actif est l'état bas, et lorsque le transistor 600 est canal N, l'entrée 118 de la porte 108 reçoit un signal nsig1 complémentaire du signal sig1.

La porte 108 comprend en outre un transistor MOS 602, et un transistor MOS 604 ou un ensemble de transistor MOS 604. En figure 5, le transistor 604, ou l'ensemble des transistors 604 lorsque la porte 108 comprend plusieurs transistors 604, est représenté schématiquement sous la forme d'un bloc 606. A titre d'exemple, lorsque la porte 108 comprend plusieurs transistors MOS 604, ces transistors sont associés en série et/ou en parallèle entre un noeud 6061 relié, par exemple connecté, à la sortie 112 de la porte 108, et un noeud 6062 relié au noeud 304. Selon un autre exemple, lorsque la porte 108 ne comprend qu'un seul transistor 604, celui-ci a une borne de conduction, par exemple sa source, reliée, de préférence connectée, au noeud 6062, et une autre borne de conduction, par exemple son drain, reliée, de préférence connectée, au noeud 6061.

Le transistor 602 est connecté en série avec le transistor 604 ou avec l'ensemble des transistors 604, entre la sortie 112 et le noeud 304 de la porte 108. La grille de chaque transistor 604 est connectée à l'entrée 110 de la porte 108. Les transistors 602 et 604 sont, par exemple, à canal P. Le transistor 602 a par exemple une borne de conduction, par exemple sa source, reliée au noeud 301, et une autre borne de conduction, par exemple son drain, reliée au noeud 6062.

Le transistor 602 est configuré pour être à l'état bloqué lorsque le signal sig2 est actif. La porte 108 comprend donc, comme la porte 106, une entrée 120 de commande configurée pour recevoir un signal de commande du transistor 602, la grille du transistor 602 étant connectée à l'entrée 120 de la porte 108. A titre d'exemple, et comme cela est représenté en figure 5, lorsque l'état binaire du signal sig2 correspondant à l'état actif est l'état bas, et lorsque le transistor 602 est à canal P, l'entrée 120 de la porte 108 reçoit un signal nsig2 complémentaire du signal sig2.

Dans ce troisième mode de réalisation, le ou les transistors 504 de la porte 106 sont polarisés à partir de la tension sur le noeud 114 de la porte 106, le ou les transistors 604 de la porte 108 étant polarisés à partir de la tension sur le noeud 114 de la porte 108. Dans ce troisième mode de réalisation, la porte 106 comprend un transistor MOS 508, par exemple à canal N, et la porte 108 comprend un transistor 608, par exemple à canal P.

Dans la porte 106, le transistor 508 est en série avec le transistor 502, entre le noeud 304 et la sortie 112. Dit autrement, le transistor 508 est en série avec le transistor 502 et le transistor 504 ou l'ensemble des transistors 504. Par exemple, le transistor 508 relie le transistor 502 au bloc 506. Le transistor 508 a alors une borne de conduction, par exemple sa source, reliée, de préférence connectée, au transistor 502, et une autre borne de conduction, par exemple son drain, reliée, de préférence connectée, au noeud 5062. La grille du transistor 508 est connectée au noeud 114 de la porte 106.

Dans la porte 108, le transistor 608 est en série avec le transistor 602, entre le noeud 301 et la sortie 112 de la porte 108. Dit autrement, le transistor 608 est en série avec le transistor 602 et le transistor 604 ou l'ensemble des transistors 604. Par exemple, le transistor 608 relie le transistor 602 au bloc 606. Le transistor 608 a alors une borne de conduction, par exemple sa source, reliée, de préférence connectée, au transistor 502, et une autre borne de conduction, par exemple son drain, reliée, de préférence connectée, au noeud 6062. La grille du transistor 608 est connectée au noeud 114 de la porte 108.

Le fonctionnement des portes 106 et 108, selon ce troisième mode de réalisation, est le suivant.

Dans une phase d'initialisation, préalable à chaque mise en oeuvre d'une comparaison des tension V+ et V-, le signal sig2 est commuté à l'état actif, par exemple par un circuit de commande du comparateur. Il en résulte que les transistors 502 et 602 commutent à l'état bloqué, ce qui permet d'isoler électriquement la sortie 112 de la porte 106 du noeud 304, et la sortie 112 de la porte 108 du noeud 301. Puis, toujours pendant la phase d'initialisation, le signal sig1 est ensuite commuté à l'état actif, par exemple par le circuit de commande du comparateur, et les transistors 500 et 600 sont commutés à l'état passant. Il en résulte que la sortie 112 de la porte 106 est mise à l'état haut (Vdd) et que la sortie 112 de la porte 108 est mise à l'état bas (GND). On notera que le signal sig1 est commuté à l'état actif après le signal sig2, pour éviter la conduction croisée dans les portes 106 et 108.

A la fin de l'étape d'initialisation, les signaux sig1 et sig2 sont commutés à l'état inactif, alors que l'entrée 110 de la porte 106 est à l'état bas (GND) et que l'entrée 110 de la porte 108 est à l'état haut (Vdd) . Il en résulte que les transistors 500 et 600 commutent à l'état bloqué, et que les transistors 502 et 602 commutent à l'état passant. Comme l'entrée 110 de la porte 106 est à l'état bas (GND), le ou les transistors 504 sont bloqués. En outre, comme l'entrée 110 de la porte 108 est l'état haut (Vdd), le ou les transistors 604 sont bloqués. La sortie 112 de la porte 106 est donc dans un état de haute impédance et reste à l'état haut (Vdd), la sortie 112 de la porte 108 étant également dans un état de haute impédance et restant à l'état bas (GND). On notera que l'état bloqué des transistors 500 et 600 à la fin de l'étape d'initialisation, alors que les transistors 502 et 602 sont passants, permet d'empêcher la conduction croisée dans les portes 106 et 108.

Pendant une phase suivante de comparaison, lorsque l'entrée 110 de la porte 106 reçoit un front montant, son entrée 110 commute à l'état haut (Vdd). Il en résulte que le ou les transistors 504 commutent à l'état passant et tirent la sortie 112 de la porte 106 à l'état bas (GND), à une vitesse qui dépend de la tension sur le noeud 114 de la porte 106. En outre, lorsque l'entrée 110 de la porte 108 reçoit un front descendant, son entrée 110 commute à l'état bas (GND). Il en résulte que le ou les transistors 604 commutent à l'état passant et tirent la sortie 112 de la porte 108 à l'état haut (Vdd), à une vitesse qui dépend de la tension sur le noeud 114 de la porte 108. On notera que l'état bloqué des transistors 500 et 600 pendant la phase de comparaison, alors que les transistors 502 et 602 sont passants, permet d'empêcher la conduction croisée dans les portes 106 et 108.

On a décrit ci-dessus, en relation avec la figure 5, un troisième mode de réalisation dans lequel, pendant une phase de comparaison des tensions V+ et V-, la porte 106 reçoit un front montant et la porte 108 reçoit un front descendant.

Selon un quatrième mode de réalisation, non illustré, une phase de comparaison des tensions V+ et V- est déclenchée par un front descendant sur le noeud 104 (figure 2). Dans ce quatrième de réalisation, chaque porte 106 est alors mise en oeuvre comme la porte 108 selon le troisième mode de réalisation illustré par la figure 5, et chaque porte 108 est alors mise en oeuvre comme la porte 106 selon le troisième mode de réalisation illustré par la figure 5.

La figure 6 représente un exemple d'une porte 106 (en haut en figure 5) et d'une porte 108 (à bas en figure 6) du comparateur 1 de la figure 2, selon une variante de réalisation où l'on tire profit de la connaissance à priori du type de front sur le noeud 104 du comparateur. Plus particulièrement, la figure 6 illustre une troisième variante de réalisation dans lequel un front montant est appliqué au noeud 104 (figure 2) pour déclencher une phase de comparaison des tensions V+ et V-. Ainsi, dans cette troisième variante, pendant une phase de comparaison des tensions V+ et V-, la porte 106 reçoit un front montant et la porte 108 reçoit un front descendant. Dans l'exemple de la figure 6, les portes 106 et 108 appartiennent à la branche 100 du comparateur 1 de la figure 2, le noeud 114 de la porte 106 recevant la tension V+, et le noeud 114 de la porte 108 recevant la tension V-. Dans un autre exemple non illustré, ces portes 106 et 108 appartiennent à la branche 102, et la tension V-, respectivement V+, est reçue par le noeud 114 de la porte 106, respectivement 108.

La porte 106, respectivement 108, selon une troisième variante de réalisation illustrée par la figure 6 comprend nombreux éléments en commun avec la porte 106, respectivement 108, selon le troisième mode de réalisation illustré par la figure 5, et seules les différences entre ces portes sont ici mises en exergue.

En figure 6, chaque transistor 504, respectivement 604, de la porte 106, respectivement 108, est mis en oeuvre à partir d'une structure de type SOI, de préférence de type FDSOI.

Ces transistors 504 et 604 comprennent alors chacun une grille arrière. La grille arrière de chaque transistor 504 de la porte 106 est connectée au noeud 114 de la porte 106, et la grille arrière de chaque transistor 604 de la porte 108 est connectée au noeud 114 de la porte 108. Dans cette troisième variante, comme cela est illustré par la figure 6, le transistor 508 de la porte 106 et le transistor 608 de la porte 108 peuvent être omis. Il en résulte que les portes 106 et 108 de la figure 6 sont plus compactes que les portes 106 et 108 de la figure 5.

Le fonctionnement des portes 106 et 108 de la figure 6 est identique à celui des portes 106 et 108 de la figure 5 et ne sera pas décrit à nouveau.

On a décrit ci-dessus, en relation avec la figure 6, une troisième variante de réalisation dans laquelle, pendant une phase de comparaison des tensions V+ et V-, la porte 106 reçoit un front montant et la porte 108 reçoit un front descendant.

Selon une quatrième variante de réalisation, non illustrée, une phase de comparaison des tensions V+ et V- est déclenchée par un front descendant sur le noeud 104 (figure 2), de sorte que, pendant la phase de comparaison, la porte 106 reçoit un front descendant et la porte 108 reçoit un front montant.

Dans cette quatrième variante de réalisation, chaque porte 106 est alors mise en oeuvre comme la porte 108 selon la troisième variante de réalisation illustrée par la figure 6, et chaque porte 108 est alors mise en oeuvre comme la porte 106 selon la troisième variante de réalisation décrite en relation avec la figure 6.

La troisième variante de réalisation décrite en relation avec la figure 6 peut être combinée avec le troisième mode de réalisation décrit en relation avec la figure 5, la quatrième variante de réalisation pouvant être combinée avec le quatrième mode de réalisation. La mise en oeuvre de ces combinaisons est à la portée de la personne du métier.

De préférence, dans les troisième et quatrième modes de réalisation décrits en relation avec la figure 5, et dans les troisième et quatrième variantes de réalisation décrites en relation avec la figure 6, les portes ne comprennent qu'un seul transistor 504 et un seul transistor 604.

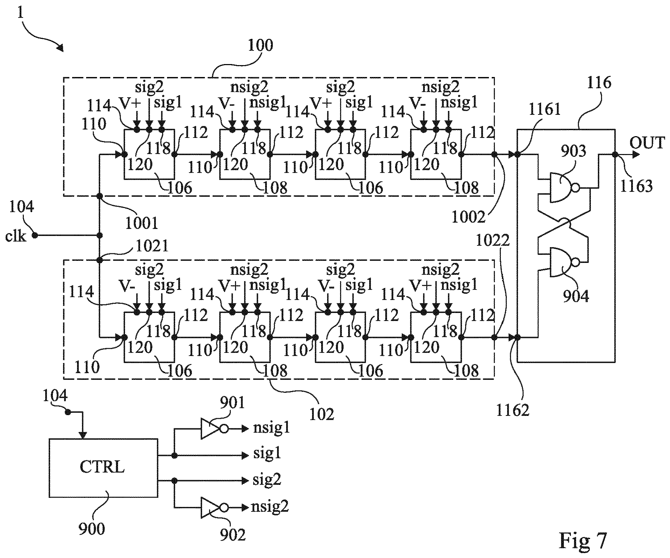

La figure 7 représente une variante de réalisation du comparateur 1 de la figure 2, dans laquelle les portes 106, 108 du comparateur sont mises en oeuvre selon le troisième mode de réalisation décrit en relation avec la figure 5, ou selon la troisième variante de réalisation décrite en relation avec la figure 6. Dit autrement, en figure 7, le front appliqué sur le noeud 104 pour déclencher une phase de comparaison des tensions V+ et V- est un front montant.

Le comparateur de la figure 7 comprend de nombreuses similitudes avec le comparateur de la figure 2, et seules les différences entre ces deux comparateurs sont ici mises en exergue.

Par rapport au comparateur 1 de la figure 2, dans le comparateur 1 de la figure 7, les portes 106, 108 comprennent chacune les entrées 118 et 120 de commande. En outre, le comparateur 1 de la figure 7 comprend un circuit de commande 900 (bloc "CTRL") configuré pour fournir les signaux sig1 et sig2. Le signal nsig1, respectivement nsig2, est obtenu à partir du signal sig1, respectivement sig2, par exemple au moyen d'un inverseur 901, respectivement 902. Les inverseurs 901 et 902 peuvent être externes au circuit 900 comme cela est représenté en figure 7, ou, en variante, faire partie de ce circuit 900. A titre d'exemple, le circuit 900 est connecté au noeud 104 pour recevoir ou fournir le signal appliqué sur ce noeud 104, par exemple le signal d'horloge clk. La mise en oeuvre du circuit 900 est à la portée de la personne du métier à partir des indications fonctionnelles données ci-dessus.

A titre d'exemple, le circuit 116 du comparateur est ici mis en oeuvre par deux portes NON-ET 903 et 904 rebouclées l'une sur l'autre, une entrée de la porte 903 étant connectée à l'entrée 1161 du circuit 116, une entrée de la porte 904 étant connectée à l'entrée 1162 du circuit 116 et la sortie de la porte 903 étant connectée à la sortie 1163 du circuit 116.

Le comparateur 1 de la figure 7 illustre le cas où le front appliqué sur le noeud 104 pour déclencher une phase de comparaison des tensions V+ et V- est un front montant, et où les portes 106, 108 sont mises en oeuvre selon le troisième mode de réalisation ou selon la troisième variante de réalisation. La mise en oeuvre du comparateur 1 dans le cas où le front appliqué sur le noeud 104 pour déclencher une phase de comparaison des tensions V+ et V- est un front descendant, à partir de portes 106 et 108 selon le quatrième mode de réalisation ou selon la quatrième variante de réalisation est à la portée de la personne du métier.

Un avantage d'un comparateur dynamique de la figure 7 est qu'il n'y a aucune conduction croisée dans les portes 106 et 108 du comparateur. Cela est vrai pendant la phase d'initialisation grâce à la commutation du signal sig2 à l'état actif avant que le signal sig1 commute à l'état actif. En effet, l'état actif du signal sig2 entraîne que les transistors 502 et 602 sont à l'état bloqué, et permettent ainsi de couper l'éventuel chemin conducteur qu'il pourrait y avoir, dans chaque porte, entre les noeuds 301 et 304. En outre, cela est également vrai pendant la phase de comparaison grâce à la commutation du signal sig1 à l'état inactif. En effet, l'état inactif du signal sig1 entraîne que les transistors 500 et 600 sont à l'état bloqué, et permettent ainsi de couper l'éventuel chemin conducteur qu'il pourrait y avoir, dans chaque porte, entre les noeuds 301 et 304.

On a décrit ci-dessus, en relation avec la figure 5 et la figure 6 des modes de réalisation et variantes des portes 106 et 108 du comparateur. Bien que cela ne soit pas revendiqué ici, ces portes peuvent être utilisées pour former des structures élémentaires pouvant être mises en oeuvre dans des circuits autres que des comparateurs dynamiques à course de front.

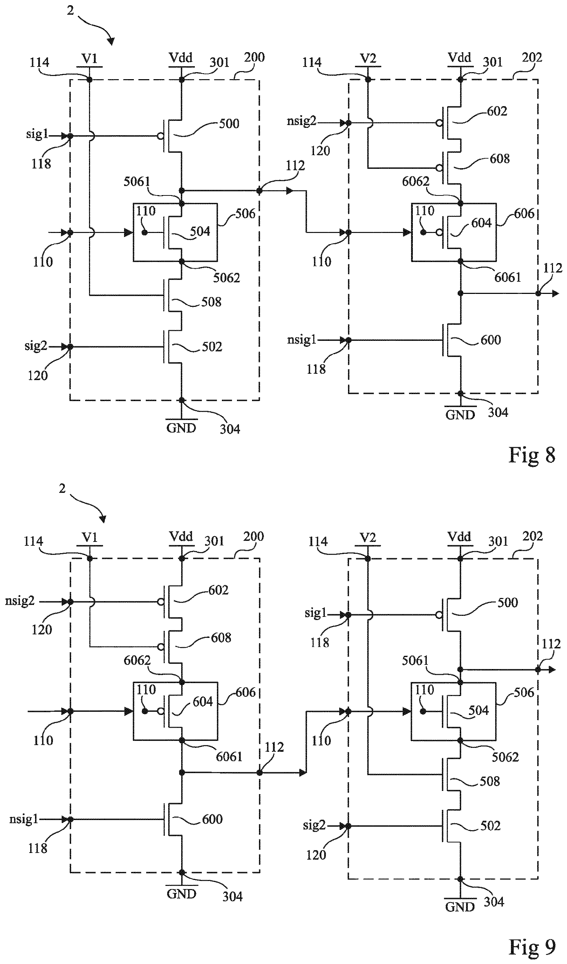

La figure 8 illustre un premier exemple d'une telle structure élémentaire 2. Plus particulièrement, dans ce premier exemple, la structure élémentaire est configurée pour recevoir un front montant. La structure élémentaire 2 correspond alors à la mise en série d'une porte 200 identique à la porte 106 selon le troisième mode de réalisation, et d'une porte 202 identique à la porte 108 selon le troisième mode de réalisation, la sortie 112 de la porte 200 étant connectée à l'entrée 110 de la porte 202.

Dans la structure 2, le noeud 114 de la porte 200 et le noeud 114 de la porte 202 reçoivent deux tensions différentes, respectivement V1 et V2. En fonction des valeurs de ces tensions V1 et V2, il est possible de régler le délai introduit par la structure 2 entre la réception d'un front montant par l'entrée de la structure 2, c'est-à-dire l'entrée 110 de la porte 200, et la fourniture d'un front montant correspondant en sortie de la structure, c'est-à-dire sur la sortie 112 de la porte 202.

La personne du métier est en mesure de mettre en oeuvre la structure 2 de la figure 8 dans le cas où la porte 200 est identique à la porte 106 selon la troisième variante de réalisation et où la porte 202 est identique à la porte 108 selon la troisième variante de réalisation.

La figure 9 illustre un deuxième exemple d'une telle structure élémentaire 2. Plus particulièrement, dans ce deuxième exemple, la structure élémentaire 2 est configurée pour recevoir un front descendant. La structure élémentaire 2 correspond alors à la mise en série d'une porte 200 identique à la porte 108 selon le troisième mode, et d'une porte 202 identique à la porte 106 selon le troisième mode de réalisation, la sortie 112 de la porte 200 étant connectée à l'entrée 110 de la porte 202. Dit autrement, la structure élémentaire 2 correspond à la mise en série d'une porte 200 identique à la porte 106 selon le quatrième mode de réalisation, et d'une porte 202 identique à la porte 108 selon le quatrième mode de réalisation.

Comme en figure 8, le noeud 114 de la porte 200 et le noeud 114 de la porte 202 reçoivent deux tensions différentes, respectivement V1 et V2. En fonction des valeurs de ces tensions V1 et V2, il est possible de régler le délai introduit par la structure 2 entre la réception d'un front descendant par l'entrée de la structure 2 et la fourniture d'un front descendant correspondant en sortie de la structure.

La personne du métier est en mesure de mettre en oeuvre la structure 2 de la figure 9 dans le cas où la porte 200 est identique à la porte 108 selon la troisième variante de réalisation et où la porte 202 est identique à la porte 106 selon la troisième variante de réalisation. Dit autrement, la personne du métier est en mesure de mettre en oeuvre la structure 2 de la figure 9 dans le cas où la porte 200 est identique à la porte 106 selon la quatrième variante de réalisation, et où la porte 202 est identique à la porte 108 selon la quatrième variante de réalisation.

Ainsi, dans les exemples ci-dessus décrit en relation avec la figure 8 et la figure 9, la première porte 200 de la structure 2 comprend :
- un premier transistor MOS (500 en figure 8, 600 en figure 9) reliant la sortie 112 de la porte 200 à un premier noeud (301 en figure 8, 304 en figure 9) ; et
- un deuxième transistor (502 en figure 8, 602 en figure 9) en série avec un troisième transistor ou un ensemble de troisièmes transistors (504 en figure 8, 604 en figure 9), entre la sortie 112 de la porte 200 et un deuxième noeud (304 en figure 8, 301 en figure 9), chaque troisième transistor ayant une grille connectée à l'entrée 110 de la porte 200, et la deuxième porte 202 comprend ;
- un quatrième transistor (600 en figure 8, 500 en figure 9) reliant la sortie 112 de la porte 202 au deuxième noeud (304 en figure 8, 301 en figure 9) ; et
- un cinquième transistor (602 en figure 8, 502 en figure 9) en série avec un sixième transistor ou un ensemble de sixièmes transistors (604 en figure 8, 504 en figure 9) entre la sortie 112 de la porte 202 et le premier noeud (301 en figure 8, 304 en figure 9), chaque sixième transistor ayant une grille connectée à l'entrée 110 de la porte 202.

Dans cette structure 2, les premier et quatrième transistors sont configurés pour être à l'état passant lorsque le signal sig1 est actif, et les deuxième et cinquième transistors sont configurés pour être à l'état bloqué lorsque le signal sig2 est actif, de manière à mettre en oeuvre, préalablement à une phase de propagation d'un front, une étape d'initialisation des portes 200 et 202 telle que décrite précédemment en relation avec la figure 5.

Dans cette structure 2, la sortie 112 de la première porte 200 est connectée à l'entrée 110 de la deuxième porte 202.

Dans cette structure 2, le ou les troisièmes transistors de la porte 200 (504 en figure 8, 604 en figure 9) sont polarisés à partir de la tension V1 sur le noeud de polarisation 114 de la porte 200, le ou les sixièmes transistors de la porte 202 (604 en figure 8, 504 en figure 9) étant polarisés à partir de la tension V2 sur le noeud de polarisation 114 de la porte 200

Plus particulièrement, selon une première mise en oeuvre illustrée par la figure 8 et la figure 9, la première porte 200 comprend en outre un septième transistor (508 en figure 8, 608 en figure 9) en série avec le ou les troisièmes transistors (504 en figure 8, 604 en figure 9), entre le deuxième noeud (304 en figure 8, 301 en figure 9) et la sortie 112 de la porte 200, la grille du septième transistor étant connectée au noeud 114 de la porte 200. Selon cette première mise en oeuvre, la deuxième porte 202 comprend en outre un huitième transistor (608 en figure 8, 508 en figure 9) en série avec le ou les sixièmes transistors (604 en figure 8, 504 en figure 9), entre le premier noeud (301 en figure 8, 304 en figure 9) et la sortie 112 de la porte 202, la grille du huitième transistor étant connectée au noeud 114 de la porte 202.

Selon une deuxième mise en oeuvre, non illustrée, chaque troisième transistor (504 en figure 8, 604 en figure 9) de la première porte 200 est mis en oeuvre à partir d'une structure SOI ou FDSOI, et chaque sixième transistor (604 en figure 8, 504 en figure 9) de la deuxième porte 202 est mis en oeuvre à partir d'une structure respectivement SOI ou FDSOI. Dans cette deuxième mise en oeuvre, la grille arrière de chaque troisième transistor (504 en figure 8, 604 en figure 9) de la première porte 200 est connectée au noeud 114 de la porte 200, la grille arrière de chaque sixième transistor (604 en figure 8, 504 en figure 9) de la porte 202 étant connectée au noeud 114 de la porte 202. Par rapport à la première mise en oeuvre, dans la deuxième mise en oeuvre de la structure 2, les septième (508 en figure 8, 608 en figure 9) et huitième (608 en figure 8, 508 en figure 9) transistors peuvent être omis.

La structure 2 proposée ci-dessus peut, par exemple, être utilisée comme élément de retard adapté à introduire un retard donné dans la propagation d'un front d'un type donné préalablement connu. Le retard introduit est déterminé par les tensions V1 et V2. Ce retard peut avantageusement être modifié en modifiant la différence entre les tensions V1 et V2, par exemple lors d'une phase d'étalonnage ou pendant l'utilisation de la structure 2 pour tenir compte d'éventuelles dispersions liées à des variations de température de fonctionnement ou de la tension d'alimentation Vdd. A titre d'exemple, la structure 2 est utilisée comme élément de retard dans un convertisseur d'une durée en un signal numérique (ou TDC de l'anglais "Time to Digital Converter").

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, la personne du métier saura adapter les modes de réalisation et variantes décrits en relation avec la figure 5, la figure 6, la figure 7, la figure 8 et la figure 9 au cas où le signal sig1 est actif à l'état haut et/ou au cas où le signal sig2 est actif à l'état haut.

Enfin, la mise en oeuvre pratique des modes de réalisation et variantes décrits est à la portée de la personne du métier.

## Revendications

1. Comparateur dynamique (1) d'une première tension (V+) et d'une deuxième tension (V-), comprenant des première (100) et deuxième (102) branches comportant chacune une même succession de premières (106) et deuxièmes (108) portes logiques alternées en série entre un premier noeud (104) et une sortie (1002 ; 1022) de ladite branche (100 ; 102), dans lequel :
chaque branche (100 ; 102) débute par une première porte (106),
chacune des premières et deuxièmes portes (106 ; 108) a un deuxième noeud (114) configuré pour recevoir une tension de polarisation,
le deuxième noeud (114) de chaque première porte (106) de la première branche (100) et de chaque deuxième porte (108) de la deuxième branche (102) reçoit la première tension(V+) et le deuxième noeud (114) de chaque deuxième porte (108) de la première branche (100) et de chaque première porte (106) de la deuxième branche (102) recevant la deuxième tension (V-), de sorte qu'un front sur le premier noeud (104) se propage dans les première et deuxième branches (100 ; 102) à des vitesses déterminées par les première et deuxième tensions (V+ ; V-), et
un ordre d'arrivée des fronts propagés par les première et deuxième branches (100 ; 102), sur les sorties (1002 ; 1022) desdites branches, détermine un résultat d'une comparaison des première et deuxième tensions (V+ ; V-).

2. Comparateur selon la revendication 1, dans lequel chacune des premières et deuxièmes portes (106 ; 108) met en oeuvre une fonction inverseuse.

3. Comparateur selon la revendication 2, dans lequel le front sur le premier noeud (104) est un front montant, la tension (V+, V-) sur le deuxième noeud (114) de chaque première porte déterminant une vitesse de commutation à l'état bas de ladite porte, et la tension (V-, V+) sur le deuxième noeud (114) de chaque deuxième porte (108) déterminant une vitesse de commutation à l'état haut de ladite porte, ou, dans lequel le front sur le premier noeud (104) est un front descendant, la tension (V+, V-) sur le deuxième noeud (114) de chaque première porte (106) déterminant une vitesse de commutation à l'état haut de ladite porte, et la tension (V-, V+) sur le deuxième noeud (114) de chaque deuxième porte (108) déterminant une vitesse de commutation à l'état bas de ladite porte.

4. Comparateur selon la revendication 2 ou 3, dans lequel chacune des premières et deuxièmes portes (106 ; 108) comprend :
au moins un premier transistor MOS (300) configuré pour commuter de ladite porte à l'état haut lorsque ladite porte reçoit un front montant ; et
au moins un deuxième transistor MOS (303) configuré pour commuter ladite porte à l'état bas lorsque ladite porte reçoit un front montant, et dans lequel :
ledit au moins un premier transistor (300) de chaque première porte (106) est polarisé à partir de la tension sur le deuxième noeud (114) de ladite porte et ledit au moins un deuxième transistor (303) de chaque deuxième porte (108) est polarisé à partir de la tension sur le deuxième noeud (114) de ladite porte, lorsque le front sur le premier noeud (104) est un front montant, ou
ledit au moins un deuxième transistor (303) de chaque première porte (106) est polarisé à partir de la tension sur le deuxième noeud (114) de ladite porte et ledit au moins un premier transistor (300) de chaque deuxième porte (108) est polarisé à partir de la tension sur le deuxième noeud (114) de ladite porte, lorsque le front sur le premier noeud est un front descendant.

5. Comparateur selon la revendication 4, dans lequel, chacune des premières et deuxièmes portes (106, 108) comprend un troisième transistor MOS (306, 307) ayant une grille connectée au deuxième noeud (114) de ladite porte, le troisième transistor (306, 307) de chaque première porte (106) étant en série avec ledit au moins un premier transistor (300) lorsque le front sur le premier noeud (104) est un front descendant, ou en série avec ledit au moins un deuxième transistor (303) lorsque le front sur le premier noeud (104) est un front montant, et le troisième transistor (306, 307) de chaque deuxième porte (108) étant en série avec ledit au moins un premier transistor (300) lorsque le front sur le premier noeud (104) est un front montant, ou en série avec ledit au moins un deuxième transistor (303) lorsque le front sur le premier noeud (104) est un front descendant.

6. Comparateur selon la revendication 4, dans lequel les premier(s) et deuxième(s) transistors (300, 303) de chaque première et deuxième portes (106, 108) sont mis en oeuvre sur semiconducteur sur isolant, éventuellement sur semiconducteur sur isolant complètement déplété, et dans lequel :
une grille arrière de chaque premier transistor (300) de chaque première porte (106) est connectée au deuxième noeud (114) de ladite première porte (106) et une grille arrière de chaque deuxième transistor (303) de chaque deuxième porte (108) est connectée au deuxième noeud (114) de ladite deuxième porte (108) quand le front sur le premier noeud (104) est un front descendant ; ou
une grille arrière de chaque deuxième transistor (303) de chaque première porte (106) est connectée au deuxième noeud (114) de ladite première porte (106) et une grille arrière de chaque premier transistor (300) de chaque deuxième porte (108) est connectée au deuxième noeud (114) de ladite deuxième porte (108) quand le front sur le premier noeud (104) est un front montant.

7. Comparateur selon l'une quelconque des revendications 4 à 6, dans lequel chacune des premières et deuxièmes portes (106, 108) comprend un unique premier transistor (300) et un unique deuxième transistor (303).

8. Comparateur selon l'une quelconque des revendications 1 à 3, dans lequel :
chaque première porte (106) comprend :
- un premier transistor MOS (500) reliant une sortie (112) de ladite porte (106) à un troisième noeud (301) ; et
- un deuxième transistor (502) en série avec un troisième transistor ou un ensemble de troisièmes transistors (504) entre la sortie (112) de ladite porte (106) et un quatrième noeud (304), chaque troisième transistor (504) ayant une grille connectée à une entrée (110) de ladite porte (106), et chaque troisième transistor (504) étant polarisé à partir de la tension sur le deuxième noeud (114) de la porte (106) ;
chaque deuxième porte (108) comprend :
- un quatrième transistor (600) reliant une sortie (112) de ladite porte (108) au quatrième noeud (304) ; et
- un cinquième transistor (602) en série avec un sixième transistor ou un ensemble de sixièmes transistors (604) entre la sortie (112) de ladite porte (108) et le troisième noeud (301), chaque sixième transistor (604) ayant une grille connectée à une entrée (110) de ladite porte (108), et chaque sixième transistor (604) étant polarisé à partir de la tension sur le deuxième noeud (114) de la porte (108) ;
les premier (500) et quatrième (600) transistors sont configurés pour être à l'état passant lorsqu'un premier signal (sig1) est actif, et les deuxième (502) et cinquième (602) transistors sont configurés pour être à l'état bloqué lorsqu'un deuxième signal (sig2) est actif ; et
le troisième noeud (301) est l'un d'un noeud (301) configuré pour recevoir une tension d'alimentation (Vdd) et d'un noeud (304) configuré pour recevoir une tension de référence (GND), le quatrième noeud (304) étant l'autre desdits noeuds (301, 304).

9. Comparateur selon la revendication 8, dans lequel :
chaque première porte (106) comprend un septième transistor MOS (508) ayant une grille connectée au deuxième noeud (114) de ladite première porte (106), le septième transistor (508) étant en série avec le deuxième transistor (502) entre le quatrième noeud (304) et la sortie (112) de ladite première porte (106) ; et
chaque deuxième porte (108) comprend un huitième transistor MOS (608) ayant une grille connectée au deuxième noeud (114) de ladite deuxième porte (108), le huitième transistor (608) étant en série avec le cinquième transistor (602) entre le troisième noeud (301) et la sortie (112) de ladite deuxième porte (108).

10. Comparateur selon la revendication 8, dans lequel :
chaque troisième transistor (504) de chaque première porte (106) est mis en oeuvre sur semiconducteur sur isolant, éventuellement sur semiconducteur sur isolant complètement déplété, et comprend une grille arrière connectée au deuxième noeud (114) de ladite porte (106) ; et
chaque cinquième transistor (604) de chaque deuxième porte (108) est mis en en oeuvre sur semiconducteur sur isolant, éventuellement sur semiconducteur sur isolant complètement déplété, et comprend une grille arrière connectée au deuxième noeud (114) de ladite porte (108).

11. Comparateur selon l'une quelconque des revendications 8 à 10, dans lequel chaque première porte (106) comprend un seul troisième transistor (504) et dans lequel chaque deuxième porte (108) comprend un seul cinquième transistor (604) .

12. Comparateur selon l'une quelconque des revendications 8 à 11, comprenant en outre un circuit de commande (900) configuré pour :
commuter le premier signal (sig1) à l'état actif puis le deuxième signal (sig2) à l'état actif pendant une phase d'initialisation préalable à une fourniture dudit front sur le premier noeud (104) ; et
commuter les premier et deuxième signaux (sig1, sig2) à un état inactif à la fin de la phase d'initialisation.

13. Comparateur selon l'une quelconque des revendications 8 à 12, dans lequel :
le front sur le premier noeud (104) est un front montant, le troisième noeud étant le noeud (301) d'application de la tension d'alimentation (Vdd) et le quatrième noeud étant le noeud (304) d'application de la tension de référence (GND) ; ou
le front sur le premier noeud (104) est un front descendant, le troisième noeud étant le noeud (304) d'application de la tension de référence (GND) et le quatrième noeud étant le noeud (301) d'application de la tension d'alimentation (Vdd) .

14. Comparateur selon l'une quelconque des revendications 1 à 13, comprenant en outre un circuit de mémorisation (116) comprenant une première entrée (1161) connectée à la sortie (1002) de la première branche (100), une deuxième entrée (1162) connectée à la sortie (1022) de la deuxième branche (102), et une sortie (1163) déterminée par l'ordre d'arrivée, sur les première et deuxième entrées (1161, 1162), des fronts propagés par les première et deuxième branches (100, 102), le circuit de mémorisation (116) comprenant, par exemple :
- deux portes NON-ET (904, 905) rebouclées l'une sur l'autre, l'une des deux portes ayant une entrée connectée à la première entrée (1161) dudit circuit (116) et l'autre des deux portes ayant une entrée connectée à la deuxième entrée (1162) dudit circuit (116) ; ou
- deux portes NON-OU rebouclées l'une sur l'autre, l'une des deux portes ayant une entrée connectée à la première entrée dudit circuit et l'autre des deux portes ayant une entrée connectée à la deuxième entrée dudit circuit ; ou
- une bascule de type D.

15. Convertisseur analogique numérique comprenant un comparateur selon l'une quelconque des revendications 1 à 14.

## Patentansprüche

1. Dynamischer Komparator (1) einer ersten Spannung (V+) und einer zweiten Spannung (V-), der einen ersten (100) und einen zweiten Zweig (102) aufweist, die jeweils eine gleiche Folge von ersten (106) und zweiten (108) abwechselnden Logikgatters aufweisen, die zwischen einem ersten Knoten (104) und einem Ausgang (1002; 1022) des Zweigs (100; 102) in Reihe geschaltet sind, wobei:
jeder Zweig (100; 102) mit einem ersten Logikgatter (106) beginnt,
jedes der ersten und zweiten Logikgatter (106; 108) einen zweiten Knoten (114) aufweist, der eingerichtet ist, eine Vorspannung zu empfangen,
der zweite Knoten (114) jedes ersten Logikgatters (106) des ersten Zweigs (100) und jedes zweiten Logikgatters (108) des zweiten Zweigs (102) die erste Spannung (V+) empfängt und der zweite Knoten (114) jedes zweiten Logikgatters (108) des ersten Zweigs (100) und jedes ersten Logikgatters (106) des zweiten Zweigs (102) die zweite Spannung (V-) empfängt, so dass sich eine Flanke an dem ersten Knoten (104) durch die ersten und zweiten Zweige (100; 102) mit Geschwindigkeiten ausbreitet, die durch die ersten und zweiten Spannungen (V+; V-) bestimmt werden, und
eine Reihenfolge des Eintreffens der Flanken, die sich durch den ersten und zweiten Zweig (100; 102) ausbreiten, an den Ausgängen (1002; 1022) der Zweige ein Ergebnis eines Vergleichs der ersten und zweiten Spannungen (V+; V-) bestimmt.

2. Komparator nach Anspruch 1, wobei jedes der ersten und zweiten Logikgatter (106; 108) eine invertierende Funktion implementiert.

3. Komparator nach Anspruch 2, wobei die Flanke am ersten Knoten (104) eine steigende Flanke ist, wobei die Spannung (V+, V-) am zweiten Knoten (114) jedes ersten Logikgatters eine Umschaltgeschwindigkeit in den niedrigen Zustand des Logikgatters bestimmt, und die Spannung (V-, V+) am zweiten Knoten (114) jedes zweiten Logikgatters (108) eine Umschaltgeschwindigkeit in den hohen Zustand des Logikgatters bestimmt, oder wobei die Flanke am ersten Knoten (104) eine fallende Flanke ist, die Spannung (V+, V-) am zweiten Knoten (114) jedes ersten Logikgatters (106) eine Umschaltgeschwindigkeit in den hohen Zustand des Logikgatters bestimmt und die Spannung (V-, V+) am zweiten Knoten (114) jedes zweiten Logikgatters (108) eine Umschaltgeschwindigkeit in den niedrigen Zustand des Logikgatters bestimmt.

4. Komparator nach Anspruch 2 oder 3, wobei jedes der ersten und zweiten Logikgatter (106; 108) Folgendes aufweist:
mindestens einen ersten MOS-Transistor (300), der eingerichtet ist, das Logikgatter in den hohen Zustand zu schalten, wenn das Logikgatter eine steigende Flanke empfängt; und
mindestens einen zweiten MOS-Transistor (303), der eingerichtet ist, das Logikgatter in den niedrigen Zustand zu schalten, wenn das Logikgatter eine steigende Flanke empfängt, und wobei:
der mindestens eine erste Transistor (300) jedes ersten Logikgatters (106) von der Spannung am zweiten Knoten (114) des Logikgatters vorgespannt wird und der mindestens eine zweite Transistor (303) jedes zweiten Logikgatters (108) von der Spannung am zweiten Knoten (114) des Logikgatters vorgespannt wird, wenn die Flanke am ersten Knoten (104) eine steigende Flanke ist, oder
der mindestens eine zweite Transistor (303) jedes ersten Logikgatters (106) von der Spannung am zweiten Knoten (114) des Logikgatters vorgespannt ist und der mindestens eine erste Transistor (300) jedes zweiten Logikgatters (108) von der Spannung am zweiten Knoten (114) des Logikgatters vorgespannt ist, wenn die Flanke am ersten Knoten eine fallende Flanke ist.

5. Komparator nach Anspruch 4, wobei jedes der ersten und zweiten Logikgatter (106, 108) einen dritten MOS-Transistor (306, 307) aufweist, dessen Gate mit dem zweiten Knoten (114) des Logikgatters verbunden ist, wobei der dritte Transistor (306, 307) jedes ersten Logikgatters (106) in Reihe mit dem mindestens einen ersten Transistor (300) ist, wenn die Flanke am ersten Knoten (104) eine fallende Flanke ist, oder in Reihe mit dem mindestens einen zweiten Transistor (303) ist, wenn die Flanke am ersten Knoten (104) eine steigende Flanke ist, und wobei der dritte Transistor (306, 307) jedes zweiten Gatters (108) in Reihe mit dem mindestens einen ersten Transistor (300) ist, wenn die Flanke am ersten Knoten (104) eine steigende Flanke ist, oder in Reihe mit dem mindestens einen zweiten Transistor (303) ist, wenn die Flanke am ersten Knoten (104) eine fallende Flanke ist.

6. Komparator nach Anspruch 4, wobei die ersten und zweiten Transistoren (300, 303) jedes ersten und zweiten Logikgatters (106, 108) auf einem Halbleiter auf Isolator, möglicherweise auf einem vollständig verarmten Halbleiter auf Isolator, ausgebildet sind, und wobei:
ein Back-Gate jedes ersten Transistors (300) jedes ersten Logikgatters (106) mit dem zweiten Knoten (114) des ersten Logikgatters (106) verbunden ist und ein Back-Gate jedes zweiten Transistors (303) jedes zweiten Logikgatters (108) mit dem zweiten Knoten (114) des zweiten Logikgatters (108) verbunden ist, wenn die Flanke an dem ersten Knoten (104) eine fallende Flanke ist; oder
ein Back-Gate jedes zweiten Transistors (303) jedes ersten Logikgatters (106) mit dem zweiten Knoten (114) des ersten Logikgatters (106) verbunden ist und ein Back-Gate jedes ersten Transistors (300) jedes zweiten Logikgatters (108) mit dem zweiten Knoten (114) des zweiten Logikgatters (108) verbunden ist, wenn die Flanke am ersten Knoten (104) eine steigende Flanke ist.

7. Komparator nach einem der Ansprüche 4 bis 6, wobei jedes der ersten und zweiten Logikgatter (106, 108) einen einzelnen ersten Transistor (300) und einen einzelnen zweiten Transistor (303) aufweist.

8. Komparator nach einem der Ansprüche 1 bis 3, wobei:
jedes erste Logikgatter (106) Folgendes aufweist:
- einen ersten MOS-Transistor (500), der einen Ausgang (112) des Logikgatters (106) mit einem dritten Knoten (301) koppelt; und
- einen zweiten Transistor (502) in Reihe mit einem dritten Transistor oder einer Anordnung dritter Transistoren (504) zwischen dem Ausgang (112) des Logikgatters (106) und einem vierten Knoten (304), wobei jeder dritte Transistor (504) ein Gate aufweist, das mit einem Eingang (110) des Logikgatters (106) verbunden ist und jeder dritte Transistor (504) von der Spannung am zweiten Knoten (114) des Logikgatters (106) vorgespannt ist;
jedes zweite Logikgatter (108) Folgendes aufweist:
- einen vierten Transistor (600), der einen Ausgang (112) des Logikgatters (108) mit dem vierten Knoten (304) koppelt; und
- einen fünften Transistor (602) in Reihe mit einem sechsten Transistor oder einer Anordnung von sechsten Transistoren (604) zwischen dem Ausgang (112) des Logikgatters (108) und dem dritten Knoten (301), wobei jeder sechste Transistor (604) ein Gate aufweist, das mit einem Eingang (110) des Logikgatters (108) verbunden ist und jeder sechste Transistor (604) von der Spannung am zweiten Knoten (114) des Logikgatters (108) vorgespannt ist;
der erste (500) und vierte (600) Transistor eingerichtet sind, im eingeschalteten Zustand zu sein, wenn ein erstes Signal (sig1) aktiv ist, und der zweite (502) und fünfte (602) Transistor eingerichtet sind, im ausgeschalteten Zustand zu sein, wenn ein zweites Signal (sig2) aktiv ist; und
der dritte Knoten (301) einer ist aus einem Knoten (301), der eingerichtet ist, eine Leistungsversorgungsspannung (Vdd) zu empfangen, und einem Knoten (304) ist, der eingerichtet ist, eine Referenzspannung (GND) zu empfangen, wobei der vierte Knoten (304) der andere der Knoten (301, 304) ist.

9. Komparator nach Anspruch 8, wobei:
jedes erste Logikgatter (106) einen siebten MOS-Transistor (508) aufweist, der ein Gate hat, das mit dem zweiten Knoten (114) des ersten Logikgatters (106) verbunden ist, wobei der siebte Transistor (508) in Reihe mit dem zweiten Transistor (502) zwischen dem vierten Knoten (304) und dem Ausgang (112) des ersten Logikgatters (106) liegt; und
jedes zweite Logikgatter (108) einen achten MOS-Transistor (608) aufweist, der ein Gate hat, das mit dem zweiten Knoten (114) des zweiten Logikgatters (108) verbunden ist, wobei der achte Transistor (608) in Reihe mit dem fünften Transistor (602) zwischen dem dritten Knoten (301) und dem Ausgang (112) des zweiten Logikgatters (108) liegt.

10. Komparator nach Anspruch 8, wobei:
jeder dritte Transistor (504) jedes ersten Logikgatters (106) auf einem Halbleiter auf Isolator, möglicherweise auf einem vollständig verarmten Halbleiter auf Isolator, ausgebildet ist und ein Back-Gate aufweist, das mit dem zweiten Knoten (114) des Logikgatters (106) verbunden ist; und
jeder fünfte Transistor (604) jedes zweiten Logikgatters (108) auf einem Halbleiter auf Isolator, möglicherweise auf einem vollständig verarmten Halbleiter auf Isolator, ausgebildet ist und ein Back-Gate aufweist, das mit dem zweiten Knoten (114) des Logikgatters (108) verbunden ist.

11. Komparator nach einem der Ansprüche 8 bis 10, wobei jedes erste Logikgatter (106) einen einzelnen dritten Transistor (504) aufweist und wobei jedes zweite Logikgatters (108) einen einzelnen fünften Transistor (604) aufweist.

12. Komparator nach einem der Ansprüche 8 bis 11, der ferner eine Steuerschaltung (900) aufweist, die eingerichtet ist zum:
Schalten des ersten Signals (sig1) in den aktiven Zustand und dann des zweiten Signals (sig2) in den aktiven Zustand während einer Initialisierungsphase vor einer Zuführung der Flanke an den ersten Knoten (104); und
Schalten des ersten und zweiten Signals (sig1, sig2) in einen inaktiven Zustand am Ende der Initialisierungsphase.

13. Komparator nach einem der Ansprüche 8 bis 12, wobei:
die Flanke am ersten Knoten (104) eine steigende Flanke ist, wobei der dritte Knoten der Knoten (301) zum Anlegen der Leistungsversorgungsspannung (Vdd) ist und der vierte Knoten der Knoten (304) zum Anlegen der Referenzspannung (GND) ist; oder
die Flanke am ersten Knoten (104) eine fallende Flanke ist, wobei der dritte Knoten der Knoten (304) zum Anlegen der Referenzspannung (GND) ist und der vierte Knoten der Knoten (301) zum Anlegen der Leistungsversorgungsspannung (Vdd) ist.

14. Komparator nach einem der Ansprüche 1 bis 13, der ferner eine Speicherschaltung (116) aufweist, die einen ersten Eingang (1161), der mit dem Ausgang (1002) des ersten Zweigs (100) verbunden ist, einen zweiten Eingang (1162), der mit dem Ausgang (1022) des zweiten Zweigs (102) verbunden ist, und einen Ausgang (1163) aufweist, der durch die Reihenfolge des Eintreffens an den ersten und zweiten Eingängen (1161, 1162) der Flanken bestimmt wird, die sich durch den ersten und zweiten Zweig (100, 102) ausbreiten, wobei die Speicherschaltung (116) zum Beispiel Folgendes aufweist:
- zwei NAND-Logikgatter (904, 905), die in einer Schleife verbunden sind, wobei eines der beiden Logikgatter einen Eingang hat, der mit dem ersten Eingang (1161) der Schaltung (116) verbunden ist, und das andere der beiden Logikgatter einen Eingang hat, der mit dem zweiten Eingang (1162) der Schaltung (116) verbunden ist; oder
- zwei NOR-Logikgatter, die in einer Schleife verbunden sind, wobei ein Eingang eines der beiden Logikgatter mit dem ersten Eingang der Schaltung verbunden ist und ein Eingang des anderen der beiden Logikgatter mit dem zweiten Eingang der Schaltung verbunden ist; oder
- ein D-Typ Flip-Flop.

15. Analog-Digital-Wandler, der einen Komparator nach einem der Ansprüche 1 bis 14 aufweist.

## Claims

1. Dynamic comparator (1) of a first voltage (V+) and of a second voltage (V-) comprising first (100) and second branches (102) each comprising a same succession of first (106) and second (108) alternated logic gates in series between a first node (104) and an output (1002; 1022) of said branch (100; 102), wherein:
each branch (100; 102) starts with a first logic gate (106),
each of the first and second logic gates (106; 108) has a second node (114) configured to receive a bias voltage,
the second node (114) of each first logic gate (106) of the first branch (100) and of each second logic gate (108) of the second branch (102) receives the first voltage (V+) and the second node (114) of each second logic gate (108) of the first branch (100) and of each first logic gate (106) of the second branch (102) receiving the second voltage (V-), so that an edge on the first node (104) propagates through the first and second branches (100; 102) at speeds determined by the first and second voltages (V+; V-), and
an order of arrival of the edges propagated by the first and second branches (100; 102), on the outputs (1002; 1022) of said branches, determines a result of a comparison of the first and second voltages (V+; V-).

2. Comparator according to claim 1, wherein each of the first and second logic gates (106; 108) implements an inverting function.

3. Comparator according to claim 2, wherein the edge on the first node (104) is a rising edge, the voltage (V+, V-) on the second node (114) of each first logic gate determining a speed of switching to the low state of said logic gate, and the voltage (V-, V+) on the second node (114) of each second logic gate (108) determining a speed of switching to the high state of said logic gate, or wherein the edge on the first node (104) is a falling edge, the voltage (V+, V-) on the second node (114) of each first logic gate (106) determining a speed of switching to the high state of said logic gate, and the voltage (V-, V+) on the second node (114) of each second logic gate (108) determining a speed of switching to the low state of said logic gate.

4. Comparator according to claim 2 or 3, wherein each of the first and second logic gates (106; 108) comprises:
at least one first MOS transistor (300) configured to switch said logic gate to the high state when said logic gate receives a rising edge; and
at least one second MOS transistor (303) configured to switch said logic gate to the low state when said logic gate receives a rising edge, and wherein:
said at least one first transistor (300) of each first logic gate (106) is biased from the voltage on the second node (114) of said logic gate and said at least one second transistor (303) of each second logic gate (108) is biased from the voltage on the second node (114) of said logic gate, when the edge on the first node (104) is a rising edge, or
said at least one second transistor (303) of each first logic gate (106) is biased from the voltage on the second node (114) of said logic gate and said at least one first transistor (300) each second logic gate (108) is biased from the voltage on the second node (114) of said logic gate, when the edge on the first node is a falling edge.

5. Comparator according to claim 4, wherein each of the first and second logic gates (106, 108) comprises a third MOS transistor (306, 307) having a gate connected to the second node (114) of said logic gate, the third transistor (306, 307) of each first logic gate (106) being in series with said at least one first transistor (300) when the edge on the first node (104) is a falling edge, or in series with said at least one second transistor (303) when the edge on the first node (104) is a rising edge, and the third transistor (306, 307) of each second gate (108) being in series with said at least one first transistor (300) when the edge on the first node (104) is a rising edge, or in series with said at least one second transistor (303) when the edge on the first node (104) is a falling edge.

6. Comparator according to claim 4, wherein the first and second transistors (300, 303) of each first and second logic gates (106, 108) are implemented on semiconductor on insulator, possible on fully depleted semiconductor on insulator, and wherein:
a back gate of each first transistor (300) of each first logic gate (106) is connected to the second node (114) of said first logic gate (106) and a back gate of each second transistor (303) of each second logic gate (108) is connected to the second node (114) of said second logic gate (108) when the edge on the first node (104) is a falling edge; or
a back gate of each second transistor (303) of each first logic gate (106) is connected to the second node (114) of said first logic gate (106) and a back gate of each first transistor (300) of each second logic gate (108) is connected to the second node (114) of said second logic gate (108) when the edge on the first node (104) is a rising edge.

7. Comparator according to any of claims 4 to 6, wherein each of the first and second logic gates (106, 108) comprises a single first transistor (300) and a single second transistor (303).

8. Comparator according to any of claims 1 to 3, wherein:
each first logic gate (106) comprises:
- a first MOS transistor (500) coupling an output (112) of said logic gate (106) to a third node (301); and
- a second transistor (502) in series with a third transistor or an assembly of third transistors (504) between the output (112) of said logic gate (106) and a fourth node (304), each third transistor (504) having a gate connected to an input (110) of said logic gate (106), and each third transistor (504) being biased from the voltage on the second node (114) of the logic gate (106);
each second logic gate (108) comprises:
- a fourth transistor (600) coupling an output (112) of said logic gate (108) to the fourth node (304); and
- a fifth transistor (602) in series with a sixth transistor or an assembly of sixth transistors (604) between the output (112) of said logic gate (108) and the third node (301), each sixth transistor (604) having a gate connected to an input (110) of said logic gate (108), and each sixth transistor (604) being biased from the voltage on the second node (114) of the logic gate (108);
the first (500) and fourth (600) transistors are configured to be in the on state when a first signal (sig1) is active, and the second (502) and fifth (602) transistors are configured to be in the off state when a second signal (sig2) is active; and
the third node (301) is one of a node (301) configured to receive a power supply voltage (Vdd) and of a node (304) configured to receive a reference voltage (GND), the fourth node (304) being the other one of said nodes (301, 304).

9. Comparator according to claim 8, wherein:
each first logic gate (106) comprises a seventh MOS transistor (508) having a gate connected to the second node (114) of said first logic gate (106), the seventh transistor (508) being in series with the second transistor (502) between the fourth node (304) and the output (112) of said first logic gate (106); and
each second logic gate (108) comprises an eighth MOS transistor (608) having a gate connected to the second node (114) of said second logic gate (108), the eighth transistor (608) being in series with the fifth transistor (602) between the third node (301) and the output (112) of said second logic gate (108).

10. Comparator according to claim 8, wherein:
each third transistor (504) of each first logic gate (106) is implemented on semiconductor on insulator, possibly on fully depleted semiconductor on insulator, and comprises a back gate connected to the second node (114) of said logic gate (106); and
each fifth transistor (604) of each second logic gate (108) is implemented on semiconductor on insulator, possibly on fully depleted semiconductor on insulator, and comprises a back gate connected to the second node (114) of said logic gate (108).

11. Comparator according to any of claims 8 to 10, wherein each first logic gate (106) comprises a single third transistor (504) and wherein each second logic gate (108) comprises a single fifth transistor (604).

12. Comparator according to any of claims 8 to 11, further comprising a control circuit (900) configured to:
switch the first signal (sig1) to the active state and then the second signal (sig2) to the active state during an initialization phase prior to a supply of said edge on the first node (104); and
switch the first and second signals (sig1, sig2) to an inactive state at the end of the initialization phase.

13. Comparator according to any of claims 8 to 12, wherein:
the edge on the first node (104) is a rising edge, the third node being the node (301) of application of the power supply voltage (Vdd) and the fourth node being the node (304) of application of the reference voltage (GND); or
the edge on the first node (104) is a falling edge, the third node being the node (304) of application of the reference voltage (GND) and the fourth node being the node (301) of application of the power supply voltage (Vdd) .

14. Comparator according to any of claims 1 to 13, further comprising a memorizing circuit (116) comprising a first input (1161) connected to the output (1002) of the first branch (100), a second input (1162) connected to the output (1022) of the second branch (102), and an output (1163) determined by the order of arrival, on the first and second inputs (1161, 1162), of the edges propagated by the first and second branches (100, 102), the memorizing circuit (116) for example comprising:
- two NAND logic gates (904, 905) connected in a loop, one of the two logic gates having an input connected to the first input (1161) of said circuit (116) and the other one of the two logic gates having an input connected to the second input (1162) of said circuit (116) ; or
- two NOR logic gates connected in a loop, one of the two logic gates having an input connected to the first input of said circuit and the other one of the two logic gates having an input connected to the second input of said circuit; or
- a D-type flip-flop.

15. Analog-to-digital converter comprising a comparator according to any of claims 1 to 14.
